(19) Europäisches Patentamt
European Patent Office
Office européen des brevets

(11) **EP 2 992 068 B1**

(12) **EUROPÄISCHE PATENTSCHRIFT**

(45) Veröffentlichungstag und Bekanntmachung des Hinweises auf die Patenterteilung:
**03.01.2018 Patentblatt 2018/01**

(21) Anmeldenummer: **14716243.2**

(22) Anmeldetag: **07.04.2014**

(51) Int Cl.:
***C09K 11/77*** *(2006.01)*

(86) Internationale Anmeldenummer:
**PCT/EP2014/000923**

(87) Internationale Veröffentlichungsnummer:
**WO 2014/177247 (06.11.2014 Gazette 2014/45)**

(54) **LEUCHTSTOFFE**

PHOSPHORS

LUMINOPHORES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.05.2013 EP 13002368**

(43) Veröffentlichungstag der Anmeldung:
**09.03.2016 Patentblatt 2016/10**

(73) Patentinhaber: **Merck Patent GmbH**
**64293 Darmstadt (DE)**

(72) Erfinder:
• **WINKLER, Holger**
**64291 Darmstadt (DE)**
• **PETRY, Ralf**
**64347 Griesheim (DE)**
• **VOSGROENE, Tim**
**64372 Ober-Ramstadt (DE)**
• **BARNEKOW, Peter**
**68766 Hockenheim (DE)**
• **JUESTEL, Thomas**
**58455 Witten (DE)**
• **SUESSEMILCH, Claudia**
**45155 Muenster (DE)**

(56) Entgegenhaltungen:
EP-A1- 1 764 402    WO-A1-2012/045393
CN-A- 1 364 848    JP-A- 2009 079 094
US-B1- 6 409 938

**Beschreibung**

Die vorliegende Erfindung betrifft Granatleuchtstoffe, ein Verfahren zu deren Herstellung sowie deren Verwendung als Konversionsleuchtstoffe. Die vorliegende Erfindung betrifft zudem ein Emissions-konvertierendes Material enthaltend den erfindungsgemäßen Konversionsleuchtstoff sowie dessen Verwendung in Lichtquellen, insbesondere pc-LEDs (phosphor converted light emitting devices). Weitere Gegenstände der vorliegenden Erfindung sind Lichtquellen, insbesondere pc-LEDs, und Beleuchtungseinheiten, die eine Primärlichtquelle und das erfindungsgemäße Emissions-konvertierende Material enthalten.

Seit mehr als 100 Jahren werden anorganische Leuchtstoffe entwickelt, um emissive Bildschirme, Röntgenverstärker und Strahlungs- bzw. Lichtquellen spektral so anzupassen, dass sie Anforderungen des jeweiligen Anwendungsgebietes möglichst optimal erfüllen und gleichzeitig möglichst wenig Energie verbrauchen. Dabei ist die Art der Anregung, d. h. die Natur der primären Strahlungsquelle und das erforderliche Emissionsspektrum von entscheidender Bedeutung für die Auswahl der Wirtsgitter und der Aktivatoren.

Insbesondere für Fluoreszenzlichtquellen für die Allgemeinbeleuchtung, also Niederdruckentladungslampen und Leuchtdioden, werden ständig neue Leuchtstoffe entwickelt, um die Energieeffizienz, Farbwiedergabe und Stabilität weiter zu erhöhen.

Um durch die additive Farbmischung weiß emittierende anorganische LEDs (light emitting diodes) zu erhalten, gibt es prinzipiell drei verschiedene Ansätze:

(1) Die RGB LEDs (rot + grün + blau LEDs), bei denen weißes Licht durch Mischung des Lichtes drei verschiedener im roten, grünen und blauen Spektralbereich emittierender Leuchtdioden erzeugt wird.

(2) Die Systeme UV LED + RGB Leuchtstoff, bei denen ein im UV-Bereich emittierender Halbleiter (Primärlichtquelle) das Licht an die Umgebung abgibt, in der drei verschiedene Leuchtstoffe (Konversionsleuchtstoffe) angeregt werden, im roten, grünen und blauen Spektralbereich zu emittieren. Alternativ können zwei verschiedene Leuchtstoffe verwendet werden, die gelb oder orange und blau emittieren.

(3) Komplementäre Systeme, bei denen ein emittierender Halbleiter (Primärlichtquelle) beispielsweise blaues Licht abgibt, das einen oder mehrere Leuchtstoffe (Konversionsleuchtstoffe) anregt, im beispielsweise gelben Bereich Licht zu emittieren. Durch Mischung des blauen und des gelben Lichts entsteht dann weißes Licht. Alternativ können zwei oder mehr Leuchtstoffe verwendet werden, die beispielsweise grünes oder gelbes und orange oder rotes Licht emittieren.

Binär-komplementäre Systeme haben den Vorteil, dass sie mit nur einer Primärlichtquelle und - im einfachsten Fall - mit nur einem Konversionsleuchtstoff in der Lage sind, weißes Licht zu produzieren. Das Bekannteste dieser Systeme besteht aus einem Indium-Aluminium-Gallium-Nitrid-Chip als Primärlichtquelle, der Licht im blauen Spektralbereich abgibt, und einem Cer-dotierten Yttrium-Aluminium-Granat (YAG:Ce) als Konversionsleuchtstoff, der im blauen Bereich angeregt wird und Licht im gelben Spektralbereich abgibt. Verbesserungen des Farbwiedergabe-Indexes sowie der Stabilität der Farbtemperatur sind jedoch wünschenswert. Auch weitere Granatleuchtstoffe der allgemeinen Formel $(Y,Gd,Lu,Tb)_3(Al,Ga,Sc)_5O_{12}$:Ce sind für diese Verwendung bekannt. Granatleuchtstoffe sind aufgrund der hohen Stabilität gegenüber Luft und Feuchtigkeit von besonderem Interesse.

Die binär-komplementären Systeme benötigen also bei Verwendung eines blau emittierenden Halbleiters als Primärlichtquelle einen gelben Konversionsleuchtstoff, um weißes Licht wiederzugeben. Alternativ können grün und rot emittierende Konversionsleuchtstoffe verwendet werden. Verwendet man alternativ dazu als Primärlichtquelle einen im violetten Spektralbereich oder im nahen UV-Spektrum emittierenden Halbleiter, so muss entweder eine RGB-Leuchtstoffmischung oder eine dichromatische Mischung von zwei komplementäres Licht emittierenden Konversionsleuchtstoffen verwendet werden, um weißes Licht zu erhalten. Bei der Verwendung eines Systems mit einer Primärlichtquelle im violetten oder UV-Bereich und zwei komplementären Konversionsleuchtstoffen können Leuchtdioden mit einem besonders hohen Lumenäquivalent bereitgestellt werden. Ein weiterer Vorteil einer dichromatischen Leuchtstoffmischung ist die geringere spektrale Wechselwirkung und der damit verbundene höhere "Package Gain" ("Packungsdichte").

Deshalb gewinnen heute insbesondere anorganische fluoreszierende Pulver, die im blauen und/oder UV-Bereich des Spektrums angeregt werden können, immer stärker an Bedeutung als Konversionsleuchtstoffe für Lichtquellen, insbesondere für pc-LEDs.

Ein wesentlicher Nachteil der Verwendung einer Primärlichtquelle mit einem breitbandig emittierenden $Ce^{3+}$-dotierten Granatleuchtstoff bzw. einer LED mit einem dichromatischen Spektrum (blau + gelb-orange) ist deren Abhängigkeit der Farbwiedergabe von der Farbtemperatur. Geringe Farbtemperaturen ($T_c$ < 5000 K) lassen sich durch das Fehlen tiefroter Spektralanteile zudem nicht mit einer genügend hohen Farbwiedergabe (CRI > 80) realisieren.

Es besteht ständig Bedarf an neuen Konversionsleuchtstoffen, die im blauen oder UV-Bereich angeregt werden können und Licht im sichtbaren Bereich, insbesondere im grünen Spektralbereich abgeben.

Es ist somit eine Aufgabe der vorliegenden Erfindung, Verbindungen bereit zu stellen, welche gegenüber einfachen Cer-dotierten Granatleuchtstoffen einen höheren Anteil der Emission im roten Spektralbereich aufweisen, bzw. welche ein Emissionsspektrum mit gegenüber einfachen Cer-dotierten Granatleuchtstoffen verschobenem Emissionsmaximum aufweisen. Dies ermöglicht dem Fachmann eine größere Auswahl an geeigneten Materialien zur Herstellung weiß emittierender Vorrichtungen.

Überraschend wurde gefunden, dass geeignete Granatleuchtstoffe mit hoher Photolumineszenzquantenausbeute erhalten werden, wenn man zusätzlich zur Cer-Dotierung $Mn^{2+}$ als Co-Dotierung einsetzt und der Einbau des zweiwertigen Mangans auf den Gitterplätzen des dreiwertigen Aluminiums durch den Einbau von Halogenidionen auf den Gitterplätzen des Sauerstoffs kompensiert wird. Diese Phosphore weisen im Vergleich zu rein $Ce^{3+}$-dotierten Granaten eine rot-verschobene Emissionsbande auf.

Aus JP 2009/079094 sind Granatleuchtstoffe bekannt, welche zusätzlich zu $Ce^{3+}$ mit $Mn^{2+}$ codotiert sind. Der Ladungsausgleich erfolgt hier über den gleichzeitigen Einbau von Silicium statt Aluminium. Granatleuchtstoffe mit $Mn^{2+}$ Codotierung, welche gleichzeitig Halogen enthalten, sind nicht beschrieben.

Aus US 6,409,938 B1 ist ein Verfahren zur Herstellung von YAG:$Ce^{3+}$ bekannt, worin ein $AlF_3$-Flussmittel zu einem Ausgangspulver, das Yttrium, Cer, Aluminium und Sauerstoff enthält, hinzugegeben wird und das Pulver in einer schwach reduzierenden Atmosphäre, die durch Verdampfen von Holzkohle erzeugt wird, gesintert wird. Der erhaltene Leuchtstoff hat die Zusammensetzung $A_3D_5E_{12}$:$Ce^{3+}$, wobei A mindestens eines von Y, Gd, Lu, Sm und La umfasst; D mindestens eines von Al, Ga, Sc und In umfasst; E Sauerstoff umfasst; Y, Al und Sauerstoff das Kristallgitter des Leuchtstoffs umfassen; und der Leuchtstoff eine Leuchtkraft von mehr als 435 Lumen pro Watt aufweist.

Gegenstand der vorliegenden Erfindung ist daher eine Verbindung der folgenden Formel (1),

$$M_{3-x}Ce_x(Al_{5-y-z-w}Ga_zSc_w)Mn_yO_{12-y}Hal_y \qquad (1)$$

wobei für die verwendeten Symbole und Indizes gilt:

M       ist ausgewählt aus der Gruppe bestehend aus Y, Gd, Lu oder Tb oder Mischungen aus zwei oder mehr dieser Metalle;

Hal     ist ausgewählt aus der Gruppe bestehend aus F, Cl, Br oder I oder Mischungen aus zwei oder mehr dieser Elemente;

$$0.005 \leq x \leq 0.3;$$

$$0 < y \leq 0.2;$$

$$0 \leq z \leq 1.0;$$

$$0 \leq w \leq 1.0.$$

Die erfindungsgemäßen Verbindungen werden durch die Verwendung von $MnHal_2$, insbesondere $MnF_2$, zur Co-Dotierung erhalten.

Alle hier beschriebenen mit $Ce^{3+}$ und $Mn^{2+}$co-dotierten Granatleuchtstoffe weisen Emissionsbanden zwischen 520 und 600 nm und eine hohe Photolumineszenz-Quantenausbeute auf.

Die erfindungsgemäßen Verbindungen sind üblicherweise im blauen Spektralbereich, vorzugsweise bei etwa 450 nm, anregbar und emittieren üblicherweise mit einem Emissionsmaximum im grünen oder gelben Spektralbereich. Dabei weisen die erfindungsgemäßen Verbindungen ein breites Emissionsspektrum bis in einen Bereich von über 600 nm auf und decken somit auch einen Teil des roten Spektralbereich ab.

Im Kontext dieser Anmeldung wird als blaues Licht solches Licht bezeichnet, dessen Emissionsmaximum zwischen 400 und 459 nm liegt, als cyanfarbenes Licht solches, dessen Emissionsmaximum zwischen 460 und 505 nm liegt, als grünes Licht solches, dessen Emissionsmaximum zwischen 506 und 545 nm liegt, als gelbes Licht solches, dessen Emissionsmaximum zwischen 546 und 565 nm liegt, als orange Licht solches, dessen Emissionsmaximum zwischen 566 und 600 nm liegt und als rotes Licht solches, dessen Emissionsmaximum zwischen 601 und 670 nm liegt.

In einer bevorzugten Ausführungsform der Erfindung ist M ausgewählt aus der Gruppe Y, Lu oder einer Mischung aus Y und Lu. Besonders bevorzugt steht M für Lu. Dabei enthält die Verbindung bevorzugt Al oder eine Kombination von Al mit bis zu 20 Atom% Ga.

In einer weiteren bevorzugten Ausführungsform der Erfindung ist Hal ausgewählt aus der Gruppe bestehend aus F, Cl und Br, besonders bevorzugt F und Cl und ganz besonders bevorzugt F.

In nochmals einer weiteren bevorzugten Ausführungsform der Erfindung gilt für den Index x: $0.005 \leq x \leq 0.20$, besonders bevorzugt $0.010 \leq x \leq 0.15$, ganz besonders bevorzugt $0.015 \leq x \leq 0.10$.

In nochmals einer weiteren bevorzugten Ausführungsform der Erfindung gilt für den Index y: $0.001 \leq x \leq 0.2$, besonders bevorzugt $0.003 \leq x \leq 0.1$, ganz besonders bevorzugt $0.005 \leq x \leq 0.05$.

In nochmals einer weiteren bevorzugten Ausführungsform der Erfindung gilt für den Index z: $0 \leq z \leq 1$, besonders bevorzugt $0 \leq z \leq 0.5$. Ganz besonders bevorzugt ist z = 0.

In nochmals einer weiteren bevorzugten Ausführungsform der Erfindung gilt für den Index w: $0 \leq w \leq 1$, besonders bevorzugt $0 \leq w \leq 0.5$. Ganz besonders bevorzugt ist w = 0.

Besonders bevorzugt ist mindestens einer der beiden Indizes z und w = 0. Wenn also z > 0 ist, ist w bevorzugt = 0, und wenn w > 0 ist, ist z bevorzugt = 0.

In einer besonders bevorzugten Ausführungsform der Erfindung gelten die oben genannten Bevorzugungen gleichzeitig. Besonders bevorzugt sind daher Verbindungen der Formel (1), für die gilt:

M ist ausgewählt aus der Gruppe bestehend aus Y oder Lu oder Mischungen dieser Metalle;

Hal ist ausgewählt aus der Gruppe bestehend aus F oder Cl oder Mischungen dieser Elemente;

$$0.005 \leq x \leq 0.20;$$

$$0.001 \leq y \leq 0.2;$$

$$0 \leq z \leq 0.5;$$

$$0 \leq w \leq 0.5.$$

Ganz besonders bevorzugt sind Verbindungen der Formel (1), für die gilt:

M ist ausgewählt aus der Gruppe bestehend aus Y oder Lu;

Hal ist F;

$$0.010 \leq x \leq 0.15, \text{ bevorzugt } 0.015 \leq x \leq 0.10;$$

$$0.003 \leq y \leq 0.1, \text{ bevorzugt } 0.005 \leq y \leq 0.05;$$

z=0;

w = 0.

Ein weiterer Gegenstand der vorliegenden Erfindung ist ein Verfahren zur Herstellung einer Verbindung gemäß Formel (1), umfassend die Schritte:

a) Herstellung einer Lösung enthaltend M, Al, Mn, Ce, Hal und gegebenenfalls Ga und/oder Sc;
b) Zugabe von Zitronensäure oder Weinsäure;
c) Trocknen; und
d) Kalzinieren der Mischung bei erhöhter Temperatur.

Dabei können die verschiedenen Salze in Schritt a) entweder nacheinander in beliebiger Reihenfolge oder gleichzeitig zugegeben werden. Die Zugabe der Zitronen- bzw. Weinsäure erfolgt nach der Zugabe aller Salze in Schritt a). Bevorzugt ist die Verwendung von Zitronensäure.

Dabei wird das Ion M bevorzugt in Form des entsprechenden Oxids $M_2O_3$ eingesetzt, und die Lösung von M wird durch Lösen in einer Säure, insbesondere in Salpetersäure, hergestellt.

Weiterhin wird Mn und Hal bevorzugt in Form eines Salzes $MnHal_2$, insbesondere $MnF_2$, eingesetzt. Es können auch anderen wasserlösliche Mangansalze eingesetzt werden, beispielsweise Manganacetat. In diesem Fall muss das Halogen Hal separat zugesetzt werden, beispielsweise in Form des Ammoniumsalzes $(NH_4)Hal$.

Für Al eignen sich verschiedenen Salze, beispielsweise Nitrat, Acetat oder andere wasserlösliche Al-Salze. Bevorzugt sind die Nitratsalze.

Für das vorhandene Ce eignen sich verschiedenen Salze, beispielsweise Nitrat, Oxalat oder Acetat. Bevorzugt ist Cernitrat.

Wenn die erfindungsgemäße Verbindung Ga und/oder Sc enthält, so werden diese Elemente bevorzugt in Form ihrer Nitrate, Acetate oder Oxalate eingesetzt.

Die Lösung in Schritt a) ist bevorzugt eine saure Lösung. Bevorzugt wird zunächst $M_2O_3$ in einer Säure, insbesondere in konzentrierter Salpetersäure gelöst. Hierzu werden die anderen Salze als Feststoff oder als wässrige Lösung, insbesondere als Feststoff gegeben.

Das Trocknen der Mischung erfolgt bevorzugt bei erhöhter Temperatur, beispielsweise in einem Temperaturbereich von 70-150 °C, beispielsweise in einem Trockenschrank.

Das Kalzinieren der Mischung in Schritt d) des erfindungsgemäßen Verfahrens wird bevorzugt in zwei Schritten durchgeführt.

Dabei wird der erste Kalzinierungsschritt an Luft bzw. unter oxidierenden Bedingungen durchgeführt. Bevorzugt ist hier eine Reaktionszeit von 0.5 bis 10 h, besonders bevorzugt von 1 bis 5 h, ganz besonders bevorzugt von 2 bis 4 h, und eine Temperatur im Bereich von 800 bis 1300 °C, besonders bevorzugt von 900 bis 1100 °C, ganz besonders bevorzugt von 950 bis 1050 °C.

In einer bevorzugten Ausführungsform der Erfindung wird das vorkalzinierte Produkt aus dem ersten Kalzinierungsschritt abgekühlt und zerkleinert, beispielsweise gemörsert, bevor es dem zweiten Kalzinierungsschritt unterworfen wird.

Der zweite Kalzinierungsschritt wird bevorzugt unter reduzierenden bzw. zumindest unter nicht-oxidierenden Bedingungen durchgeführt. Bevorzugt ist hier eine Reaktionszeit von 1 bis 15 h, besonders bevorzugt von 2 bis 10 h, ganz besonders bevorzugt von 3 bis 5 h, und eine Temperatur im Bereich von 1400 bis 1800 °C, besonders bevorzugt zwischen 1500 und 1700 °C, ganz besonders bevorzugt zwischen 1550 bis 1650 °C.

Die nicht-oxidierenden bzw. reduzierenden Bedingungen werden dabei z. B. mit inerten Gasen oder Kohlenmonoxid, Formiergas oder Wasserstoff oder Vakuum oder Sauerstoffmangel-Atmosphäre eingestellt. Bevorzugt ist eine CO-Atmosphäre.

Das Kalzinieren kann beispielsweise so durchgeführt werden, dass die erhaltenen Mischungen in einem Hochtemperaturofen, beispielsweise in einem Kammerofen, eingebracht werden. Als Reaktionsgefäß eignet sich beispielsweise ein Korundtiegel mit Deckel.

Es ist bevorzugt, wenn die erfindungsgemäßen Verbindungen nach dem zweiten Kalzinierungsschritt zerkleinert werden, beispielsweise durch Mörsern.

In nochmals einer weiteren Ausführungsform können die erfindungsgemäßen Verbindungen beschichtet werden. Hierfür eignen sich alle Beschichtungsverfahren, wie sie gemäß dem Stand der Technik dem Fachmann bekannt sind und für Phosphore angewandt werden. Geeignete Materialien für die Beschichtung sind insbesondere Metalloxide und Nitride, insbesondere Erdmetalloxide, wie $Al_2O_3$, und Erdmetallnitride, wie AlN, sowie $SiO_2$. Dabei kann die Beschichtung beispielsweise durch Wirbelschichtverfahren oder nasschemisch durchgeführt werden. Geeignete Beschichtungsverfahren sind beispielsweise bekannt aus JP 04-304290, WO 91/10715, WO 99/27033, US 2007/0298250, WO 2009/065480 und WO 2010/075908. Das Ziel der Beschichtung kann einerseits eine höhere Stabilität der Leuchtstoffe, beispielsweise gegen Luft oder Feuchtigkeit, sein. Ziel kann aber auch eine verbesserte Ein- und Auskopplung von Licht durch geeignete Wahl der Oberfläche der Beschichtung sowie der Brechungsindizes des Beschichtungsmaterials sein.

Nochmals ein weiterere Gegenstand der vorliegenden Erfindung ist die Verwendung der erfindungsgemäßen Verbindung als Leuchtstoff oder Konversionsleuchtstoff, insbesondere zur teilweisen oder vollständigen Konversion der blauen oder im nahen UV-liegenden Emission einer Leuchtdiode in Licht mit größerer Wellenlänge.

Im Folgenden werden die erfindungsgemäßen Verbindungen daher auch als Leuchtstoffe bezeichnet.

Ein weiterer Gegenstand der vorliegenden Erfindung ist daher ein Emissions-konvertierendes Material umfassend eine erfindungsgemäße Verbindung. Das Emissions-konvertierende Material kann aus der erfindungsgemäßen Verbindung bestehen und wäre in diesem Fall mit dem oben definierten Begriff "Konversionsleuchtstoff" gleichzusetzen. Es kann auch bevorzugt sein, dass das erfindungsgemäße Emissions-konvertierende Material neben der erfindungsgemäßen Verbindung noch weitere Konversionsleuchtstoffe enthält. In diesem Fall enthält das erfindungsgemäße Emissions-konvertierende Material vorzugsweise eine Mischung aus mindestens zwei Konversionsleuchtstoffen, wobei mindestens einer davon eine erfindungsgemäße Verbindung ist. Es ist insbesondere bevorzugt, dass die mindestens zwei Konversionsleuchtstoffe Leuchtstoffe sind, die Licht von Wellenlängen emittieren, die komplementär zueinander sind.

Erfindungsgemäße Verbindungen in geringen Mengen eingesetzt ergeben bereits gute LED-Qualitäten. Die LED-Qualität wird dabei über übliche Parameter, wie beispielsweise den Color Rendering Index (CRI), die Correlated Color Temperature (CCT), Lumenäquivalente oder absolute Lumen bzw. den Farbpunkt in CIE x und y Koordinaten beschrieben.

Der Color Rendering Index (CRI) ist eine dem Fachmann geläufige, einheitslose lichttechnische Größe, welche die Farbwiedergabetreue einer künstlichen Lichtquelle mit derjenigen des Sonnenlichtes bzw. und Filamentlichtquellen vergleicht (die beiden letzt genannten besitzen einen CRI von 100).

Die Correlated Color Temperature (CCT) ist eine dem Fachmann geläufige, lichttechnische Größe mit der Einheit Kelvin. Je höher der Zahlenwert, desto höher ist der Blauanteil des Lichts und desto kälter erscheint dem Betrachter das Weißlicht einer künstlichen Strahlungsquelle. Die CCT folgt dem Konzept des Schwarzlichtstrahlers, dessen Farbtemperatur die so genannte Plancksche Kurve im CIE Diagramm beschreibt.

Das Lumenäquivalent ist eine dem Fachmann geläufige lichttechnische Größe mit der Einheit lm/W, die beschreibt, wie groß der photometrische Lichtstrom in Lumen einer Lichtquelle bei einer bestimmten radiometrischen Strahlungsleistung mit der Einheit Watt, ist. Je höher das Lumenäquivalent ist, desto effizienter ist eine Lichtquelle.

Das Lumen ist eine dem Fachmann geläufige, photometrische lichttechnische Größe, welche den Lichtstrom einer Lichtquelle, der ein Maß für die gesamte von einer Strahlungsquelle ausgesandte sichtbare Strahlung ist, beschreibt. Je größer der Lichtstrom, desto heller erscheint die Lichtquelle dem Beobachter.

CIE x und CIE y stehen für die Koordinaten im dem Fachmann geläufigen CIE Normfarbdiagramm (hier Normalbeobachter 1931), mit denen die Farbe einer Lichtquelle beschrieben wird.

Alle oben aufgeführten Größen können nach dem Fachmann geläufigen Methoden aus den Emissionsspektren der Lichtquelle berechnet werden.

Die Anregbarkeit der erfindungsgemäßen Leuchtstoffe erstreckt sich über einen weiten Bereich, der von etwa 410 nm bis 530 nm, bevorzugt 430 nm bis zu etwa 500 nm reicht. Üblicherweise liegt das Maximum der Anregungskurve bei ca. 450 nm.

Ein weiterer Gegenstand der vorliegenden Erfindung ist eine Lichtquelle, die mindestens eine Primärlichtquelle und mindestens eine erfindungsgemäße Verbindung enthält. Dabei liegt das Emissionsmaximum der Primärlichtquelle üblicherweise im Bereich 410 nm bis 530 nm, bevorzugt 430 nm bis zu etwa 500 nm. Insbesondere bevorzugt ist ein Bereich zwischen 440 und 480 nm, wobei die primäre Strahlung teilweise oder vollständig durch den erfindungsgemäßen Leuchtstoff in längerwellige Strahlung konvertiert wird.

In einer bevorzugten Ausführungsform der erfindungsgemäßen Lichtquelle handelt es sich bei der Primärlichtquelle um ein lumineszentes Indium-AluminiumGalliumNitrid, insbesondere der Formel $In_iGa_jAl_kN$, wobei $0 \leq i$, $0 \leq j$, $0 \leq k$, und $i+j+k=1$ ist.

Dem Fachmann sind mögliche Formen von derartigen Lichtquellen bekannt. Es kann sich hierbei um lichtemittierende LED-Chips unterschiedlichen Aufbaus handeln.

In einer weiteren bevorzugten Ausführungsform der erfindungsgemäßen Lichtquelle handelt es sich bei der Primärlichtquelle um eine lumineszente auf ZnO, TCO (transparent conducting oxide), ZnSe oder SiC basierende Anordnung oder auch um eine auf einer organischen lichtemittierenden Schicht basierende Anordnung (OLED).

In einer weiteren bevorzugten Ausführungsform der erfindungsgemäßen Lichtquelle handelt es sich bei der Primärlichtquelle um eine Quelle, die Elektrolumineszenz und/oder Photolumineszenz zeigt. Weiterhin kann es sich bei der Primärlichtquelle auch um eine Plasma- oder Entladungsquelle handeln.

Entsprechende erfindungsgemäße Lichtquellen werden auch als Leuchtdioden oder LEDs bezeichnet.

Die erfindungsgemäßen Leuchtstoffe können einzeln oder als Mischung mit den dem Fachmann geläufigen folgenden Leuchtstoffen eingesetzt werden. Entsprechende für Mischungen prinzipiell geeignete Leuchtstoffe sind beispielsweise:

$Ba_2SiO_4:Eu^{2+}$, $BaSi_2O_5:Pb^{2+}$, $Ba_xSr_{1-x}F_2:Eu^{2+}$, $BaSrMgSi_2O_7:Eu^{2+}$, $BaTiP_2O_7$, $(Ba,Ti)_2P_2O_7:Ti$, $BaY_2F_8:Er^{3+},Yb^+$, $Be_2SiO_4:Mn^{2+}$, $Bi_4Ge_3O_{12}$, $CaAl_2O_4:Ce^{3+}$, $CaLa_4O_7:Ce^{3+}$, $CaAl_2O_4:Eu^{2+}$, $CaAl_2O_4:Mn^{2+}$, $CaAl_4O_7:Pb^{2+},Mn^{2+}$, $CaAl_2O_4:Tb^{3+}$, $Ca_3Al_2Si_3O_{12}:Ce^{3+}$, $Ca_3Al_2Si_3O_{12}:Ce^{3+}$, $Ca_3Al_2Si_3O_{,2}:Eu^{2+}$, $Ca_2B_5O_9Br:Eu^{2+}$ $Ca_2B_5O_9Cl:Eu^{2+}$, $Ca_2B_5O_9Cl:Pb^{2+}$, $CaB_2O_4:Mn^{2+}$, $Ca_2B_2O_5:Mn^{2+}$, $CaB_2O_4:Pb^{2+}$, $CaB_2P_2O_9:Eu^{2+}$, $Ca_5B_2SiO_{10}:Eu^{3+}$, $Ca_{0.5}Ba_{0.5}Al_{12}O_{19}:Ce^{3+},Mn^{2+}$, $Ca_2Ba_3(PO_4)_3Cl:Eu^{2+}$, $CaBr_2:Eu^{2+}$ in $SiO_2$, $CaCl_2:Eu^{2+}$ in $SiO_2$, $CaCl_2:Eu^{2+},Mn^{2+}$ in $SiO_2$, $CaF_2:Ce^{3+}$, $CaF_2:Ce^{3+},Mn^{2+}$, $CaF_2:Ce^{3+},Tb^{3+}$, $CaF_2:Eu^{2+}$, $CaF_2:M_n^{2+}$, $CaGa_2O_4:Mn^{2+}$, $CaGa_4O_7:Mn^{2+}$, $CaGa_2S_4:Ce^{3+}$, $CaGa_2S_4:Eu^{2+}$, $CaGa_2S_4:Mn^{2+}$, $CaGa_2S_4:Pb^{2+}$, $CaGeO_3:Mn^{2+}$, $CaI_2:Eu^{2+}$ in $SiO_2$, $CaI_2:Eu^{2+},Mn^{2+}$ in $SiO_2$, $CaLaBO_4:Eu^{3+}$, $CaLaB_3O_7:Ce^{3+},Mn^{2+}$, $Ca_2La_2BO_{6.5}:Pb^{2+}$, $Ca_2MgSi_2O_7$, $Ca_2MgSi_2O_7:Ce^{3+}$, $CaMgSi_2O_6:Eu^{2+}$, $Ca_3MgSi_2O_8:Eu^{2+}$, $Ca_2MgSi_2O_7:Eu^{2+}$, $CaMgSi_2O_6:Eu^{2+},Mn^{2+}$, $Ca_2MgSi_2O_7:Eu^{2+},Mn^{2+}$, $CaMoO_4$, $CaMoO_4:Eu^{3+}$, $CaO:Bi^{3+}$, $CaO:Cd^{2+}$, $CaO:Cu^+$, $CaO:Eu^{3+}$, $CaO:Eu^{3+}$, $Na^+$, $CaO:Mn^{2+}$, $CaO:Pb^{2+}$, $CaO:Sb^{3+}$, $CaO:Sm^{3+}$, $CaO:Tb^{3+}$, $CaO:Tl$, $CaO:Zn^{2+}$, $Ca_2P_2O_7:Ce^{3+}$, $\alpha$-$Ca_3(PO_4)_2:Ce^{3+}$, $\beta$-$Ca_3(PO_4)_2:Ce^{3+}$, $Ca_5(PO_4)_3Cl:Eu^{2+}$, $Ca_5(PO_4)_3Cl:Mn^{2+}$, $Ca_5(PO_4)_3Cl:Sb^{3+}$, $Ca_5(PO_4)_3Cl:Sn^{2+}$, $\beta$-$Ca_3(PO_4)_2:Eu^{2+},Mn^{2+}$, $Ca_5(PO_4)_3F:Mn^{2+}$, $Ca_s(PO_4)_3F:Sb^{3+}$, $Ca_s(PO_4)_3F:Sn^{2+}$, $\alpha$-$Ca_3(PO_4)_2:Eu^{2+}$, $\beta$-$Ca_3(PO_4)_2:Eu^{2+}$, $Ca_2P_2O_7:Eu^{2+}$,

$Ca_2P_2O_7$:$Eu^{2+}$,$Mn^{2+}$, $CaP_2O_6$:$Mn^{2+}$, $\alpha$-$Ca_3(PO_4)_2$:$Sn^{2+}$, $\beta$-$Ca_3(PO_4)_2$:$Sn^{2+}$, $\beta$-$Ca_2P_2O_7$:Sn,Mn, $\alpha$-$Ca_3(PO_4)_2$:Tr, $CaS$:$Bi^{3+}$, $CaS$:$Bi^{3+}$,Na, $CaS$:$Ce^{3+}$, $CaS$:$Eu^{2+}$, $CaS$:$Cu^+$,$Na^+$, $CaS$:$La^{3+}$, $CaS$:$Mn^{2+}$, $CaSO_4$:Bi, $CaSO_4$:$Ce^{3+}$, $CaSO_4$:$Ce^{3+}$,$Mn^{2+}$, $CaSO_4$:$Eu^{2+}$, $CaSO_4$:$Eu^{2+}$,$M_n^{2+}$, $CaSO_4$:$Pb^{2+}$, $CaS$:$Pb^{2+}$, $CaS$:$Pb^{2+}$,Cl, $CaS$:$Pb^{2+}$,$Mn^{2+}$, $CaS$:$Pr^{3+}$,$Pb^{2+}$,Cl, $CaS$:$Sb^{3+}$, $CaS$:$Sb^{3+}$,Na, $CaS$:$Sm^{3+}$, $CaS$:$Sn^{2+}$, $CaS$:$Sn^{2+}$,F, $CaS$:$Tb^{3+}$, $CaS$:$Tb^{3+}$,Cl, $CaS$:$Y^{3+}$, $CaS$:$Yb^{2+}$, $CaS$:$Yb^{2+}$,Cl, $CaSiO_3$:$Ce^{3+}$, $Ca_3SiO_4Cl_2$:$Eu^{2+}$, $Ca_3SiO_4Cl_2$:$Pb^{2+}$, $CaSiO_3$:$Eu^{2+}$, $CaSiO_3$:$Mn^{2+}$,Pb, $CaSiO_3$:$Pb^{2+}$, $CaSiO_3$:$Pb^{2+}$,$Mn^{2+}$, $CaSiO_3$:$Ti^{4+}$, $CaSr_2(PO_4)_2$:$Bi^{3+}$, $\beta$-$(Ca,Sr)_3(PO_4)_2$:$Sn^{2+}Mn^{2+}$, $CaTi_{0.9}Al_{0.1}O_3$:$Bi^{3+}$, $CaTiO_3$:$Eu^{3+}$, $CaTiO_3$:$Pr^{3+}$, $Ca_5(VO_4)_3Cl$, $CaWO_4$, $CaWO_4$:$Pb^{2+}$, $CaWO_4$:W, $Ca_3WO_6$:U, $CaYAlO_4$:$Eu^{3+}$, $CaYBO_4$:$Bi^{3+}$, $CaYBO_4$:$Eu^{3+}$, $CaYB_{0.8}O_{3.7}$:$Eu^{3+}$, $CaY_2ZrO_6$:$Eu^{3+}$, $(Ca,Zn,Mg)_3(PO_4)_2$:Sn, $(Ce,Mg)BaAl_{11}O_{18}$:Ce, $(Ce,Mg)SrAl_{11}O_{18}$:Ce, $CeMgAl_{11}O_{19}$:Ce:Tb, $Cd_2B_6O_{11}$:$Mn^{2+}$, $CdS$:$Ag^+$,Cr, $CdS$:In, $CdS$:In, $CdS$:In,Te, $CdS$:Te, $CdWO_4$, $CsF$, $CsI$, $CsI$:$Na^+$, $CsI$:Tl, $(ErCl_3)_{0.25}(BaCl_2)_{0.75}$, $GaN$:Zn, $Gd_3Ga_5O_{12}$:$Cr^{3+}$, $Gd_3Ga_5O_{12}$:Cr,Ce, $GdNbO_4$:$Bi^{3+}$, $Gd_2O_2S$:$Eu^{3+}$, $Gd_2O_2Pr^{3+}$, $Gd_2O_2S$:Pr,Ce,F, $Gd_2O_2S$:$Tb^{3+}$, $Gd_2SiO_5$:$Ce^{3+}$, $KAl_{11}O_{17}$:$Tl^+$, $KGa_{11}O_{17}$:$Mn^{2+}$, $K_2La_2Ti_3O_{10}$:Eu, $KMgF_3$:$Eu^{2+}$, $KMgF_3$:$Mn^{2+}$, $K_2SiF_6$:$Mn^{4+}$, $LaAl_3B_4O_{12}$:$Eu^{3+}$, $LaAlB_2O_6$:$Eu^{3+}$, $LaAlO_3$:$Eu^{3+}$, $LaAlO_3$:$Sm^{3+}$, $LaAsO_4$:$Eu^{3+}$, $LaBr_3$:$Ce^{3+}$, $LaBO_3$:$Eu^{3+}$, $LaCl_3$:$Ce^{31}$, $La_2O_3$:$Bi^{3+}$, La-$OBr$:$Tb^{3+}$, $LaOBr$:$Tm^{3+}$, $LaOCl$:$Bi^{3+}$, $LaOCl$:$Eu^{3+}$, $LaOF$:$Eu^{3+}$, $La_2O_3$:$Eu^{3+}$, $La_2O_3$:$Pr^{3+}$, $La_2O_2S$:$Tb^{3+}$, $LaPO_4$:$Ce^{3+}$, $LaPO_4$:$Eu^{3+}$, $LaSiO_3Cl$:$Ce^{3+}$, $LaSiO_3Cl$:$Ce^{3+}$,$Tb^{3+}$, $LaVO_4$:$Eu^{3+}$, $La_2W_3O_{12}$:$Eu^{3+}$, $LiAlF_4$:$Mn^{2+}$, $LiAl_5O_8$:$Fe^{3+}$, $LiAlO_2$:$Fe^{3+}$, $LiAlO_2$:$Mn^{2+}$, $LiAl_5O_8$:$Mn^{2+}$, $Li_2CaP_2O_7$:$Ce^{3+}$,$Mn^{2+}$, $LiCeBa_4Si_4O_{14}$:$Mn^{2+}$, $LiCeSrBa_3Si_4O_{14}$:$Mn^{2+}$, $LiInO_2$:$Eu^{3+}$, $LiInO_2$:$Sm^{3+}$, $LiLaO_2$:$Eu^{3+}$, $LuAlO_3$:$Ce^{3+}$, $(Lu,Gd)_2SiO_5$:$Ce^{3+}$, $Lu_2SiO_5$:$Ce^{3+}$, $Lu_2Si_2O_7$:$Ce^{3+}$, $LuTaO_4$:$Nb^{5+}$, $Lu_{1-x}Y_xAlO_3$:$Ce^{3+}$, $MgAl_2O_4$:$Mn^{2+}$, $MgSrAl_{10}O_{17}$:Ce, $MgB_2O_4$:$Mn^{2+}$, $MgBa_2(PO_4)_2$:$Sn^{2+}$, $MgBa_2(PO_4)_2$:U, $MgBaP_2O_7$:$Eu^{2+}$, $MgBaP_2O_7$:$Eu^{2+}$,$Mn^{2+}$, $MgBa_3Si_2O_8$:$Eu^{2+}$, $MgBa(SO_4)_2$:$Eu^{2+}$, $Mg_3Ca_3(PO_4)_4$:$Eu^{2+}$, $MgCaP_2O_7$:$Mn^{2+}$, $Mg_2Ca(SO_4)_3$:$Eu^{2+}$, $Mg_2Ca(SO_4)_3$:$Eu^{2+}$,$Mn^2$, $MgCeAl_nO_{19}$:$Tb^{3+}$, $Mg_4(F)GeO_6$:$Mn^{2+}$, $Mg_4(F)(Ge,Sn)O_6$:$Mn^{2+}$, $MgF_2$:$Mn^{2+}$, $MgGa_2O_4$:$Mn^{2+}$, $Mg_8Ge_2O_{11}F_2$:$Mn^{4+}$, $MgS$:$Eu^{2+}$, $MgSiO_3$:$Mn^{2+}$, $Mg_2SiO_4$:$Mn^{2+}$, $Mg_3SiO_3F_4$:$Ti^{4+}$, $MgSO_4$:$Eu^{2+}$, $MgSO_4$:$Pb^{2+}$, $MgSrBa_2Si_2O_7$:$Eu^{2+}$, $MgSrP_2O_7$:$Eu^{2+}$, $MgSr_5(PO_4)_4$:$Sn^{2+}$, $MgSr_3Si_2O_8$:$Eu^{2+}$,$Mn^{2+}$, $Mg_2Sr(SO_4)_3$:$Eu^{2+}$, $Mg_2TiO_4$:$Mn^{4+}$, $MgWO_4$, $MgYBO_4$:$Eu^{3+}$, $Na_3Ce(PO_4)_2$:$Tb^{3+}$, $Na_{1.23}K_{0.42}Eu_{0.12}TiSi_4O_{11}$:$EU^{3+}$, $Na_{1.23}K_{0.42}Eu_{0.12}TiSi_5O_{13}\cdot xH_2O$:$Eu^{3+}$, $Na_{1.29}K_{0.46}Er_{0.08}TiSi_4O_{11}$:$Eu^{3+}$, $Na_2Mg_3Al_2Si_2O_{10}$:Tb, $Na(Mg_{2-x}Mn_x)LiSi_4O_{10}F_2$:Mn, $NaYF_4$:$Er^{3+}$, $Yb^{3+}$, $NaYO_2$:$Eu^{3+}$, P46(70%) + P47 (30%), $SrAl_{12}O_{19}$:$Ce^{3+}$, $Mn^{2+}$, $SrAl_2O_4$:$Eu^{2+}$, $SrAl_4O_7$:$Eu^{3+}$, $SrAl_{12}O_{19}$:$Eu^{2+}$, $SrAl_2S_4$:$Eu^{2+}$, $Sr_2B_5O_9Cl$:$Eu^{2+}$, $SrB_4O_7$:$Eu^{2+}$(F,Cl,Br), $SrB_4O_7$:$Pb^{2+}$, $SrB_4O_7$:$Pb^{2+}$, $Mn^{2+}$, $SrB_8O_{13}$:$Sm^{2+}$, $Sr_xBa_yCl_zAl_2O_{4-z/2}$: $Mn^{2+}$, $Ce^{3+}$, $SrBaSiO_4$:$Eu^{2+}$, $Sr(Cl,Br,I)_2$:$Eu^{2+}$ in $SiO_2$, $SrCl_2$:$Eu^{2+}$ in $SiO_2$, $Sr_5Cl(PO_4)_3$:Eu, $Sr_wF_xB_4O_{6.5}$:$Eu^{2+}$, $Sr_wF_xB_yO_z$:$Eu^{2+}$,$Sm^{2+}$, $SrF_2$:$Eu^{2+}$, $SrGa_{12}O_{19}$:$Mn^{2+}$, $SrGa_2S_4$:$Ce^{3+}$, $SrGa_2S_4$:$Eu^{2+}$, $SrGa_2S_4$:$Pb^{2+}$, $SrIn_2O_4$:$Pr^{3+}$, $Al^{3+}$, $(Sr,Mg)_3(PO_4)_2$:Sn, $SrMgSi_2O_6$:$Eu^{2+}$, $Sr_2MgSi_2O_7$:$Eu^{2+}$, $Sr_3MgSi_2O_8$:$Eu^{2+}$, $SrMoO_4$:U, $SrO\cdot 3B_2O_3$:$Eu^{2+}$,Cl, $\beta$-$SrO\cdot 3B_2O_3$:$Pb^{2+}$, $\beta$-$SrO\cdot 3B_2O_3$:$Pb^{2+}$,$Mn^{2+}$, $\alpha$-$SrO\cdot 3B_2O_3$:$Sm^{2+}$, $Sr_6P_5BO_{20}$:Eu, $Sr_5(PO_4)_3Cl$:$Eu^{2+}$, $Sr_5(PO_4)_3Cl$:$Eu^{2+}$,$Pr^{3+}$, $Sr_5(PO_4)_3Cl$:$Mn^{2+}$, $Sr_5(PO_4)_3Cl$:$Sb^{3+}$, $Sr_2P_2O_7$:$Eu^{2+}$, $\beta$-$Sr_3(PO_4)_2$:$EU^{2+}$, $Sr_5(PO_4)_3F$:$Mn^{2+}$, $Sr_5(PO_4)_3F$:$Sb^{3+}$, $Sr_5(PO_4)_3F$:$Sb^{3+}$,$Mn^{2+}$, $Sr_5(PO_4)_3F$:$Sn^{2+}$, $Sr_2P_2O_7$:$Sn^{2+}$, $\beta$-$Sr_3(PO_4)_2$:$Sn^{2+}$, $\beta$-$Sr_3(PO_4)_2$:$Sn^{2+}$,$Mn^{2+}$(Al), $SrS$:$Ce^{3+}$, $SrS$:$Eu^{2+}$, $SrS$:$Mn^{2+}$, $SrS$:$Cu^+$,Na, $SrSO_4$:Bi, $SrSO_4$:$Ce^{3+}$, $SrSO_4$:$Eu^{2+}$, $SrSO_4$:$Eu^{2+}$,$Mn^{2+}$, $Sr_5Si_4O_{10}Cl_6$:$Eu^{2+}$, $Sr_2SiO_4$:$EU^{2+}$, $SrTiO_3$:$Pr^{3+}$, $SrTiO_3$:$Pr^{3+}$,$Al^{3+}$, $SrY_2O_3$:$Eu^{3+}$, $ThO_2$:$Eu^{3+}$, $ThO_2$:$Pr^{3+}$, $ThO_2$:$Tb^{3+}$, $YAl_3B_4O_{12}$:$Bi^{3+}$, $YAl_3B_4O_{12}$:$Ce^{3+}$, $YAl_3B_4O_{12}$:$Ce^{3+}$,Mn, $YAl_3B_4O_{12}$:$Ce^{3+}$,$Tb^{3+}$, $YAl_3B_4O_{12}$:$Eu^{3+}$, $YAl_3B_4O_{12}$:$EU^{3+}$,$Cr^{3+}$, $YAl_3B_4O_{12}$:$Th^{4+}$,$Ce^{3+}$,$Mn^{2+}$, $YAlO_3$:$Ce^{3+}$, $Y_3Al_5O_{12}$:$Ce^{3+}$, $Y_3Al_5O_{12}$:$Cr^{3+}$, $YAlO_3$:$Eu^{3+}$, $Y_3Al_5O_{12}$:$Eu^{3r}$, $Y_4Al_2O_9$:$Eu^{3+}$, $Y_3Al_5O_{12}$:$Mn^{4+}$, $YAlO_3$:$Sm^{3+}$, $YAlO_3$:$Tb^{3+}$, $Y_3Al_5O_{12}$:$Tb^{3+}$, $YAsO_4$:$Eu^{3+}$, $YBO_3$:$Ce^{3+}$, $YBO_3$:$Eu^{3+}$, $YF_3$:$Er^{3+}$,$Yb^{3+}$, $YF_3$:$Mn^{2+}$, $YF_3$:$Mn^{2+}$,$Th^{4+}$, $YF_3$:$Tm^{3+}$,$Yb^{3+}$, $(Y,Gd)BO_3$:Eu, $(Y,Gd)BO_3$:Tb, $(Y,Gd)_2O_3$:$Eu^{3+}$, $Y_{1.34}Gd_{0.60}O_3$(Eu,Pr), $Y_2O_3$:$Bi^{3+}$, $YOBr$:$EU^{3+}$, $Y_2O_3$:Ce, $Y_2O_3$:$Er^{3+}$, $Y_2O_3$:$Eu^{3+}$, $Y_2O_3$:$Ce^{3+}$,$Tb^{3+}$, $YOCl$:$Ce^{3+}$, $YOCl$:$Eu^{3+}$, $YOF$:$Eu^{3+}$, $YOF$:$Tb^{3+}$, $Y_2O_3$:$Ho^{3+}$, $Y_2O_2S$:$Eu^{3+}$, $Y_2O_2S$:$Pr^{3+}$, $Y_2O_2S$:$Tb^{3+}$, $Y_2O_3$:$Tb^{3+}$, $YPO_4$:$Ce^{3+}$, $YPO_4$:$Ce^{3+}$,$Tb^{3+}$, $YPO_4$:$Eu^{3+}$, $YPO_4$:$Mn^{2+}$,$Th^{4+}$, $YPO_4$:$V^{5+}$, $Y(P,V)O_4$:Eu, $Y_2SiO_5$:$Ce^{3+}$, $YTaO_4$, $YTaO_4$:$Nb^{5+}$, $YVO_4$:$Dy^{3+}$, $YVO_4$:$Eu^{3+}$, $ZnAl_2O_4$:$Mn^{2+}$, $ZnB_2O_4$:$Mn^{2+}$, $ZnBa_2S_3$:$Mn^{2+}$, $(Zn,Be)_2SiO_4$:$Mn^{2+}$, $Zn_{0.4}Cd_{0.6}S$:Ag, $Zn_{0.6}Cd_{0.4}S$:Ag, $(Zn,Cd)S$:Ag,Cl, $(Zn,Cd)S$:Cu, $ZnF_2$:$Mn^{2+}$, $ZnGa_2O_4$, $ZnGa_2O_4$:$Mn^{2+}$, $ZnGa_2S_4$:$Mn^{2+}$, $Zn_2GeO_4$:$Mn^{2+}$, $(Zn,Mg)F_2$:$Mn^{2+}$, $ZnMg_2(PO_4)_2$:$Mn^{2+}$, $(Zn,Mg)_3(PO_4)_2$:$Mn^{2+}$, $ZnO$:$Al^{3+}$,$Ga^{3+}$, $ZnO$:$Bi^{3+}$, $ZnO$:$Ga^{3+}$, $ZnO$:Ga, $ZnO$-$CdO$:Ga, $ZnO$:S, $ZnO$:Se, $ZnO$:Zn, $ZnS$:$Ag^+$,$Cl^-$, $ZnS$:Ag,Cu,Cl, $ZnS$:Ag,Ni, $ZnS$:Au,In, $ZnS$-$CdS$ (25-75), $ZnS$-$CdS$ (50-50), $ZnS$-$CdS$ (75-25), $ZnS$-$CdS$:Ag,Br,Ni, $ZnS$-$CdS$:$Ag^+$,Cl, $ZnS$-$CdS$:Cu,Br, $ZnS$-$CdS$:Cu,I, $ZnS$:$Cl^-$, $ZnS$:$Eu^{2+}$, $ZnS$:Cu, $ZnS$:$Cu^+$,$Al^{3+}$, $ZnS$:$Cu^+$,$Cl^-$, $ZnS$:Cu,Sn, $ZnS$:$Eu^{2+}$, $ZnS$:$Mn^{2+}$, $ZnS$:Mn,Cu, $ZnS$:$Mn^{2+}$,$Te^{2+}$, $ZnS$:P, $ZnS$:$P^{3-}$,$Cl^-$, $ZnS$:$Pb^{2+}$, $ZnS$:$Pb^{2+}$,$Cl^-$, $ZnS$:Pb,Cu, $Zn_3(PO_4)_2$:$Mn^{2+}$, $Zn_2SiO_4$:$Mn^{2+}$, $Zn_2SiO_4$:$Mn^{2+}$,$As^{5+}$, $Zn_2SiO_4$:Mn,$Sb_2O_2$, $Zn_2SiO_4$:$Mn^{2+}$,P, $Zn_2SiO_4$:$Ti^{4+}$, $ZnS$:$Sn^{2+}$, $ZnS$:Sn,Ag, $ZnS$:$Sn^{2+}$,$Li^+$, $ZnS$:Te,Mn, $ZnS$-$ZnTe$:$Mn^{2+}$, $ZnSe$:$Cu^+$,Cl und $ZnWO_4$.

Dabei zeigt die erfindungsgemäße Verbindung insbesondere Vorteile bei der Mischung mit weiteren Leuchtstoffen anderer Fluoreszenzfarbe bzw. beim Einsatz in LEDs gemeinsam mit solchen Leuchtstoffen. Bevorzugt werden die erfindungsgemäßen Verbindungen zusammen mit rot emittierenden Leuchtstoffen eingesetzt. Es hat sich gezeigt, dass insbesondere bei Kombination der erfindungsgemäßen Verbindungen mit rot emittierenden Leuchtstoffen die Optimierung von Beleuchtungsparametern für weiße LEDs besonders gut gelingt.

Entsprechende rot emittierende Leuchtstoffe sind dem Fachmann bekannt bzw. kann der Fachmann aus der oben aufgeführten Liste auswählen. Besonders geeignete rot emittierende Leuchtstoffe sind dabei Nitride, Oxynitride, Sialone oder Sulfide. Beispiele sind: $CaAlSiN_3$:Eu, 2-5-8-Nitride, wie $(Ca,Sr,Ba)_2Si_5N_8$:Eu, $(Ca,Sr)AlSiN_3$:Eu, $(Ca,Sr)S$:Eu, $(Ca,Sr)(S,Se)$:Eu, $(Sr,Ba,Ca)Ga_2S_4$:Eu und auch Europium-dotierte, oxynitridische Verbindungen. Weitere Beispiele für geeignete rot emittierende Verbindungen sind $MgAl_2O_4$:$Mn^{4+}$ oder $Mg_8Ge_2O_{11}F_2$:$Mn^{4+}$. In einer Variante handelt es sich bei den rot emittierenden Oxynitriden um solche der Formel

$$(EA)_{2-0,5y-x+1.5z}\, Eu_x\, Si_5\, N_{8-y+z}\, O_y \cdot n\, SiO_2$$

wobei EA für ein oder mehrere Elemente ausgewählt aus Ca, Sr und Ba steht, x für einen Wert aus dem Bereich von 0,005 bis 1 steht, y für einen Wert aus dem Bereich von 0,01 bis 3 steht, z für einen Wert aus dem Bereich von 0 bis 3 steht und n für einen Wert aus dem Bereich von 0 bis 5, bevorzugt 0 bis 2 steht. Die Herstellung und Anwendung entsprechender Verbindungen ist in WO 2011/091839 beschrieben.

In einer weiteren bevorzugten Ausführungsform der Erfindung werden rot emittierende Verbindungen der Formel

$$(EA)_{2-c+1,5z}EU_cSi_5N_{8-2/3x+z}O_x \cdot n\, SiO_2$$

eingesetzt, wobei die verwendeten Indizes die folgenden Bedeutungen aufweisen: EA steht für ein oder mehrere Elemente ausgewählt aus Ca, Sr, Ba; $0,01 \leq c \leq 0,2$; $0 < x \leq 1$; $0 \leq z \leq 3,0$ und $a + b + c \leq 2 + 1,5z$; und n steht für einen Wert im Bereich von 0 bis 5, bevorzugt 0 bis 2.

In einer weiteren bevorzugten Ausführungsform der Erfindung ist es bevorzugt, die erfindungsgemäße Verbindung als einzigen Leuchtstoff zu verwenden. Die erfindungsgemäße Verbindung zeigt durch das breite Emissionsspektrum mit hohem Rotanteil auch bei Verwendung als Einzelleuchtstoff sehr gute Ergebnisse.

In nochmals einer weiteren Ausführungsform der Erfindung ist es bevorzugt, wenn die Leuchtstoffe so auf der Primärlichtquelle angeordnet sind, dass der rot emittierende Leuchtstoff im Wesentlichen von Licht der Primärlichtquelle angestrahlt wird, während der grün emittierende Leuchtstoff im Wesentlichen von Licht angestrahlt wird, welches bereits den rot emittierenden Leuchtstoff passiert hat bzw. von diesem gestreut wurde. Dies kann realisiert werden, indem der rot emittierende Leuchtstoff zwischen Primärlichtquelle und dem grün emittierenden Leuchtstoff angebracht wird.

Die erfindungsgemäßen Leuchtstoffe bzw. Leuchtstoffkombinationen können entweder in einem Harz dispergiert (z. B. Epoxy- oder Siliconharz), oder bei geeigneten Größenverhältnissen direkt auf der Primärlichtquelle angeordnet werden oder aber von dieser, je nach Anwendung, entfernt angeordnet sein (letztere Anordnung schließt auch die "Remote phosphor Technologie" mit ein). Die Vorteile der "Remote phosphor Technologie" sind dem Fachmann bekannt und z. B. der folgenden Publikation zu entnehmen: Japanese J. of Appl. Phys. Vol. 44, No. 21 (2005). L649-L651.

In einer weiteren Ausführungsform ist es bevorzugt, wenn die optische Ankopplung zwischen dem Leuchtstoff und der Primärlichtquelle durch eine lichtleitende Anordnung realisiert wird. Dadurch ist es möglich, dass an einem zentralen Ort die Primärlichtquelle installiert wird und diese mittels lichtleitender Vorrichtungen, wie beispielsweise lichtleitenden Fasern, an den Leuchtstoff optisch angekoppelt ist. Auf diese Weise lassen sich den Beleuchtungswünschen angepasste Leuchten lediglich bestehend aus einem oder mehreren unterschiedlichen Leuchtstoffen, die zu einem Leuchtschirm angeordnet sein können, und einem Lichtleiter, der an die Primärlichtquelle angekoppelt ist, realisieren. Auf diese Weise ist es möglich, eine starke Primärlichtquelle an einen für die elektrische Installation günstigen Ort zu platzieren und ohne weitere elektrische Verkabelung, sondern nur durch Verlegen von Lichtleitern an beliebigen Orten Leuchten aus Leuchtstoffen, welche an die Lichtleiter gekoppelt sind, zu installieren.

Weitere Erfindungsgegenstände sind eine Beleuchtungseinheit, insbesondere zur Hintergrundbeleuchtung von Anzeigevorrichtungen, dadurch gekennzeichnet, dass sie mindestens eine erfindungsgemäße Lichtquelle enthält, sowie eine Anzeigevorrichtung, insbesondere Flüssigkristallanzeigevorrichtung (LC Display), mit einer Hintergrundbeleuchtung, dadurch gekennzeichnet, dass sie mindestens eine erfindungsgemäße Beleuchtungseinheit enthält.

Die Partikelgröße der erfindungsgemäßen Leuchtstoffe beträgt für den Einsatz in LEDs üblicherweise zwischen 50 nm und 30 $\mu$m, vorzugsweise zwischen 1 $\mu$m und 20 $\mu$m.

Zum Einsatz in LEDs können die Leuchtstoffe auch in beliebige äußere Formen, wie sphärische Partikel, Plättchen und strukturierte Materialien und Keramiken, überführt werden. Diese Formen werden erfindungsgemäß unter dem Begriff "Formkörper" zusammengefasst. Vorzugsweise handelt es sich bei dem Formkörper um einen "Leuchtstoffkörper". Ein weiterer Gegenstand der vorliegenden Erfindung ist somit ein Formkörper enthaltend die erfindungsgemäßen Leuchtstoffe. Herstellung und Verwendung entsprechender Formkörper ist dem Fachmann aus zahlreichen Publikationen geläufig.

Da $Mn^{2+}$ nur in den hier beschriebenen Granaten in geringen Konzentrationen (< 1 %) eingesetzt wird, ist es auch vorteilhaft, die erfindungsgemäßen Leuchtstoffe auch in Form transluzenter Keramiken zu verwenden, da in keramischen Lumineszenzkonversionsschirmen die optische Weglänge, d. h. die Dicke der keramischen Schicht, aufgrund der reduzierten Streuung gegenüber einer Pulverschicht erhöht werden kann. Ein weiterer Gegenstand der vorliegenden Erfindung ist daher eine Keramik, enthaltend mindestens eine erfindungsgemäße Verbindung. Dabei kann die Keramik nur aus der erfindungsgemäßen Verbindung bestehen. Sie kann aber auch Matrixmaterialien und/oder weitere Phosphore enthalten. Geeignete Matrixmaterialien sind beispielsweise undotierte Granate, Siliciumdioxid ($SiO_2$), Yttriumoxid ($Y_2O_3$) oder Aluminiumoxid ($Al_2O_3$).

Die erfindungsgemäßen Verbindungen weisen die folgenden vorteilhaften Eigenschaften auf:

1) Die erfindungsgemäßen Verbindungen weisen eine hohe Photolumineszenzquanteneffizienz auf.
2) Die erfindungsgemäßen Verbindungen weisen nur ein geringes thermisches Quenching auf. So liegen die $TQ_{1/2}$-Werte der erfindungsgemäßen Verbindungen üblicherweise im Bereich von über 500 K.
3) Die hohe Temperaturstabilität der erfindungsgemäßen Verbindungen ermöglicht die Anwendung der Materialien auch in thermisch hochbelasteten Lichtquellen.

Alle hier beschriebenen Erfindungsvarianten können miteinander kombiniert werden, sofern sich die jeweiligen Ausführungsformen nicht gegenseitig ausschließen. Insbesondere ist es ausgehend von der Lehre dieser Schrift im Rahmen des routinemäßigen Optimierens ein naheliegender Vorgang, gerade verschiedene hier beschriebene Varianten zu kombinieren, um zu einer konkreten besonders bevorzugten Ausführungsform zu gelangen. Die folgenden Beispiele sollen die vorliegende Erfindung verdeutlichen und zeigen insbesondere das Ergebnis solcher exemplarischer Kombinationen der beschriebenen Erfindungsvarianten. Sie sind jedoch keinesfalls als limitierend zu betrachten, sondern sollen vielmehr zur Verallgemeinerung anregen. Alle Verbindungen oder Komponenten, die in den Zubereitungen verwendet werden, sind entweder bekannt und käuflich erhältlich oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immerzu insgesamt 100% addieren. Prozentangaben sind immer im gegebenen Zusammenhang zu sehen.

**Beispiele**

**Messmethoden**

Die Phasenbildung der Proben wurde mittels Röntgendiffraktometrie überprüft. Dafür wurde das Röntgendiffraktometer Miniflex II der Firma Rigaku mit Bragg-Brentano-Geometrie verwendet. Als Strahlungsquelle wurde eine Röntgenröhre mit Cu-K$\alpha$-Strahlung ($\lambda$ = 0,15418 nm) verwendet. Die Röhre wurde mit einer Stromstärke von 15 mA und einer Spannung von 30 kV betrieben. Es wurde in einem Winkelbereich von 10-80° mit $10° \cdot min^{-1}$ gemessen.

Die Emissionsspektren wurden mit einem Fluoreszenzspektrometer der Firma Edinburgh Instruments Ltd, ausgestattet mit einer Spiegeloptik für Pulverproben, bei einer Anregungswellenlänge von 450 nm aufgenommen. Als Anregungsquelle wurde eine 450 W Xe-Lampe verwendet.

Reflexionsspektren wurden mit einem Fluoreszenzspektrometer der Firma Edinburgh Instruments Ltd bestimmt. Dafür wurden die Proben in eine mit $BaSO_4$ beschichtete Ulbricht-Kugel platziert und vermessen. Reflexionsspektren wurden in einem Bereich von 250 - 800 nm aufgenommen. Als Weißstandard wurde $BaSO_4$ (Alfa Aesar 99,998 %) verwendet. Eine 450 W Xe-Lampe diente als Anregungsquelle.

Die Anregungsspektren wurden mit einem Fluoreszenzspektrometer der Firma Edinburgh Instruments Ltd., ausgestattet mit einer Spiegeloptik für Pulverproben, bei 550 nm aufgenommen. Als Anregungsquelle wurde eine 450 W Xe-Lampe verwendet.

**Beispiel 1: Darstellung von $Lu_{3-x}Al_{5-y}O_{12-y}:Ce^{3+}(0,5\%)Mn^{2+}(0,1\%)F^-(0,1\%)$ (entspricht: $Lu_{2.985}Ce_{0.015}Al_{4.995}Mn_{0.005}O_{11.995}F_{0.005}$)**

3,6957 g $Lu_2O_3$ (0,00929 mol) werden unter Erwärmen in 15 mL Salpetersäure gelöst. Anschließend werden 11,6548 g $Al(NO_3)_3$ (0,03109 mol), 0,00289 g $MnF_2$ (0,00003 mol), 0,04029 g $Ce(NO_3)_3$ (0,00009 mol) und 15 g Zitronensäure nach und nach mit Wasser zugegeben. Die Lösung wird im Trockenschrank bei 130 °C über Nacht eingeengt und der entstandene Citratprecursor gemörsert. Das Pulver wird 3 h bei 1000 °C unter Luft vorkalziniert und anschließend gemörsert. Danach wird das Produkt 4 h bei 1700 °C unter CO-Atmosphäre geheizt und erneut gemörsert. Thermisches Quenching $TQ_{1/2}$ > 500 K.

**Beispiel 2: Darstellung von $Lu_{3-x}Al_{5-y}O_{12-y}:Ce^{3+}(1,0\%)Mn^{2+}(0,1\%)F^-(0,1\%)$ (entspricht: $Lu_{2.97}Ce_{0.03}Al_{4.995}Mn_{0.005}O_{11.995}F_{0.005}$)**

3,6795 g $Lu_2O_3$ (0,00925 mol) werden unter Erwärmen in 15 mL Salpetersäure gelöst. Anschließend werden 11,6549 g Al(NO$_3$)$_3$ (0,03109 mol), 0,00289 g MnF$_2$ (0,00003 mol), 0,08069 g Ce(NO$_3$)$_3$ (0,00019 mol) und 15 g Zitronensäure nach und nach mit Wasser zugegeben. Die Lösung wird im Trockenschrank bei 130 °C über Nacht eingeengt und der entstandene Citratprecursor gemörsert. Das Pulver wird 3 h bei 1000 °C unter Luft vorkalziniert und anschließend gemörsert. Danach wird das Produkt 4 h bei 1700 °C unter CO-Atmosphäre kalziniert und erneut gemörsert. Die Verbindung weist eine Photolumineszenz-Quantenausbeute von 94 % auf.

Thermisches Quenching TQ$_{1/2}$ > 500 K.

**Beispiel 3: Darstellung von Lu$_{3-x}$Al$_{5-y}$O$_{12-y}$:Ce$^{3+}$(1,5%)Mn$^{2+}$(0,1%)F$^-$(0,1%) (entspricht: Lu$_{2.955}$Ce$_{0.045}$Al$_{4.995}$Mn$_{0.005}$O$_{11.995}$F$_{0.005}$)**

3,6633 g Lu$_2$O$_3$ (0,00921 mol) werden unter Erwärmen in 15 mL Salpetersäure gelöst. Anschließend werden 11,6735 g Al(NO$_3$)$_3$ (0,03109 mol), 0,00289 g MnF$_2$ (0,00003 mol), 0,1212 g Ce(NO$_3$)$_3$ (0,00028 mol) und 15 g Zitronensäure nach und nach mit Wasser zugegeben. Die Lösung wird im Trockenschrank bei 130 °C über Nacht eingeengt und der entstandene Citratprecursor gemörsert. Das Pulver wird 3 h bei 1000 °C unter Luft vorkalziniert und anschließend gemörsert. Danach wird das Produkt 4 h bei 1600 °C unter CO-Atmosphäre kalziniert und erneut gemörsert.

**Beispiel 4: Darstellung von Lu$_{3-x}$Al$_{5-y}$O$_{12-y}$:Ce$^{3+}$(2,0%)Mn$^{2+}$(0,1%)F$^-$(0,1%) (entspricht: Lu$_{2.940}$Ce$_{0.060}$Al$_{4.995}$Mn$_{0.005}$O$_{11.995}$F$_{0.005}$)**

3,6471 g Lu$_2$O$_3$ (0,00917 mol) werden unter Erwärmen in 15 mL Salpetersäure gelöst. Anschließend werden 11,6829 g Al(NO$_3$)$_3$ (0,0311 mol), 0,0029 g MnF$_2$ (0,00003 mol), 0,1617 g Ce(NO$_3$)$_3$ (0,00037 mol) und 15 g Zitronensäure nach und nach mit Wasser zugegeben. Die Lösung wird im Trockenschrank bei 130 °C über Nacht eingeengt und der entstandene Citratprecursor gemörsert. Das Pulver wird 3 h bei 1000 °C unter Luft vorkalziniert und anschließend gemörsert. Danach wird das Produkt 4 h bei 1700 °C unter CO-Atmosphäre kalziniert und erneut gemörsert. Thermisches Quenching TQ$_{1/2}$ > 500 K.

**Beispiel 5: Darstellung von Lu$_{3-x}$Al$_{5-y}$O$_{12-y}$:Ce$^{3+}$(2,5%)Mn$^{2+}$(0,1%)F$^-$(0,1%) (entspricht: Lu$_{2.925}$Ce$_{0.075}$Al$_{4.995}$Mn$_{0.005}$O$_{11.995}$F$_{0.005}$)**

3,6308 g Lu$_2$O$_3$ (0,00912 mol) werden unter Erwärmen in 15 mL Salpetersäure gelöst. Anschließend werden 11,6923 g Al(NO$_3$)$_3$ (0,0312 mol), 0,0029 g MnF$_2$ (0,00003 mol), 0,2023 g Ce(NO$_3$)$_3$ (0,00047 mol) und 15 g Zitronensäure nach und nach mit Wasser zugegeben. Die Lösung wird im Trockenschrank bei 130 °C über Nacht eingeengt und der entstandene Citratprecursor gemörsert. Das Pulver wird 3 h bei 1000 °C unter Luft vorkalziniert und anschließend gemörsert. Danach wird das Produkt 4 h bei 1700 °C unter CO-Atmosphäre kalziniert und erneut gemörsert. Thermisches Quenching TQ$_{1/2}$ > 500 K.

**Beispiel 6: Darstellung von Lu$_{3-x}$Al$_{5-y}$O$_{12-y}$:Ce$^{3+}$(0,5%)Mn$^{2+}$(0,1%)F$^-$(0,5%) (entspricht: Lu$_{2.985}$Ce$_{0.015}$Al$_{4.975}$Mn$_{0.025}$O$_{11.975}$F$_{0.025}$)**

3,6908 g Lu$_2$O$_3$ (0,00928 mol) werden unter Erwärmen in 15 mL Salpetersäure gelöst. Anschließend werden 11,6007 g Al(NO$_3$)$_3$ (0,0309 mol), 0,01444 g MnF$_2$ (0,00016 mol), 0,04029 g Ce(NO$_3$)$_3$ (0,00009 mol) und 15 g Zitronensäure nach und nach mit Wasser zugegeben. Die Lösung wird im Trockenschrank bei 130 °C über Nacht eingeengt und der entstandene Citratprecursor gemörsert. Das Pulver wird 3 h bei 1000 °C unter Luft vorkalziniert und anschließend gemörsert. Danach wird das Produkt 4 h bei 1700 °C unter CO-Atmosphäre kalziniert und erneut gemörsert. Thermisches Quenching TQ$_{1/2}$ > 500 K.

**Beispiel 7: Darstellung von Lu$_{3-x}$Al$_{5-y}$O$_{12-y}$:Ce$^{3+}$(1,0%)Mn$^{2+}$(0,5%)F$^-$(0,5%) (entspricht: LU$_{2.970}$Ce$_{0.030}$Al$_{4.975}$Mn$_{0.025}$O$_{11.975}$F$_{0.025}$)**

3,6754 g Lu$_2$O$_3$ (0,00924 mol) werden unter Erwärmen in 15 mL Salpetersäure gelöst. Anschließend werden 11,6082 g Al(NO$_3$)$_3$ (0,0309 mol), 0,01445 g MnF$_2$ (0,00016 mol), 0,08069 g Ce(NO$_3$)$_3$ (0,00019 mol) und 15 g Zitronensäure nach und nach mit Wasser zugegeben. Die Lösung wird im Trockenschrank bei 130 °C über Nacht eingeengt und der entstandene Citratprecursor gemörsert. Das Pulver wird 3 h bei 1000 °C unter Luft vorkalziniert und anschließend gemörsert. Danach wird das Produkt 4 h bei 1700 °C unter CO-Atmosphäre kalziniert und erneut gemörsert.

Die Verbindung weist eine Photolumineszenzquantenausbeute von 71 % auf.

Thermisches Quenching TQ$_{1/2}$ > 500 K.

**Beispiel 8: Darstellung von $Lu_{3-x}Al_{5-y}O_{12-y}:Ce^{3+}(1,5\%)Mn^{2+}(0,5\%)F^-(0,5\%)$ (entspricht: $Lu_{2.955}Ce_{0.045}Al_{4.975}Mn_{0.025}O_{11.975}F_{0.025}$)**

3,6595 g $Lu_2O_3$ (0,00919 mol) werden unter Erwärmen in 15 mL Salpetersäure gelöst. Anschließend werden 11,6156 g $Al(NO_3)_3$ (0,03096 mol), 0,01445 g $MnF_2$ (0,00016 mol), 0,12106 g $Ce(NO_3)_3$ (0,00028 mol) und 15 g Zitronensäure nach und nach mit Wasser zugegeben. Die Lösung wird im Trockenschrank bei 130 °C über Nacht eingeengt und der entstandene Citratprecursor gemörsert. Das Pulver wird 3 h bei 1000 °C unter Luft vorkalziniert und anschließend gemörsert. Danach wird das Produkt 4 h bei 1700 °C unter CO-Atmosphäre kalziniert und erneut gemörsert. Thermisches Quenching $TQ_{1/2}$ > 500 K.

**Beispiel 9: Darstellung von $Lu_{3-x}Al_{5-y}O_{12-y}:Ce^{3+}(2,0\%)Mn^{2+}(0,5\%)F^-(0,5\%)$ (entspricht: $Lu_{2.940}Ce_{0.060}Al_{4.975}Mn_{0.025}O_{11.975}F_{0.025}$)**

3,64329 g $Lu_2O_3$ (0,00916 mol) werden unter Erwärmen in 15 mL Salpetersäure gelöst. Anschließend werden 11,6475 g $Al(NO_3)_3$ (0,03105 mol), 0,01447 g $MnF_2$ (0,00016 mol), 0,16151 g $Ce(NO_3)_3$ (0,00037 mol) und 15 g Zitronensäure nach und nach mit Wasser zugegeben. Die Lösung wird im Trockenschrank bei 130 °C über Nacht eingeengt und der entstandene Citratprecursor gemörsert. Das Pulver wird 3 h bei 1000 °C unter Luft vorkalziniert und anschließend gemörsert. Danach wird das Produkt 4 h bei 1700 °C unter CO-Atmosphäre kalziniert und erneut gemörsert. Thermisches Quenching $TQ_{1/2}$ > 500 K.

**Beispiel 10: Darstellung von $Lu_{3-x}Al_{5-y}O_{12-y}:Ce^{3+}(2,5\%)Mn^{2+}(0,5\%)F^-(0,5\%)$ (entspricht: $LU_{2,925}Ce_{0.075}A1_{4.975}Mn_{0.025}O_{11.975}F_{0.025}$)**

3,6270 g $Lu_2O_3$ (0,00912 mol) werden unter Erwärmen in 15 mL Salpetersäure gelöst. Anschließend werden 11,6268 g $Al(NO_3)_3$ (0,03099 mol), 0,01447 g $MnF_2$ (0,00016 mol), 0,20195 g $Ce(NO_3)_3$ (0,00047 mol) und 15 g Zitronensäure nach und nach mit Wasser zugegeben. Die Lösung wird im Trockenschrank bei 130 °C über Nacht eingeengt und der entstandene Citratprecursor gemörsert. Das Pulver wird 3 h bei 1000 °C unter Luft vorkalziniert und anschließend gemörsert. Danach wird das Produkt 4 h bei 1700 °C unter CO-Atmosphäre kalziniert und erneut gemörsert. Thermisches Quenching $TQ_{1/2}$ > 500 K.

**Beispiel 11: Darstellung von $Lu_{2,37}Gd_{0,6}Ce_{0,03}Mn_{0,005}Al_{3,995}GaO_{11,995}F_{0,005}$**

2,6701 g $Lu_2O_3$ werden unter Erwärmen in 15 mL Salpetersäure gelöst. Anschließend werden 8,486 g $Al(NO_3)_3$, 0,6158 g $Gd_2O_3$, 0,0027 g $MnF_2$, 0,5307 g $Ga_2O_3$, 0,0738 g $Ce(NO_3)_3$ und 15 g Zitronensäure nach und nach mit Wasser zugegeben. Die Lösung wird im Trockenschrank bei 130 °C über Nacht eingeengt und der entstandene Citratprecursor gemörsert. Das Pulver wird 3 h bei 1000 °C unter Luft vorkalziniert und anschließend gemörsert. Danach wird das Produkt 4 h bei 1600 °C unter CO-Atmosphäre geheizt und erneut gemörsert.

**Beispiel 12: Darstellung von $Lu_{2,37}Y_{0,6}Ce_{0,03}Mn_{0,005}Al_{3,995}ScO_{11.995}F_{0,005}$**

2,885 g $Lu_2O_3$ werden unter Erwärmen in 15mL Salpetersäure gelöst. Anschließend werden 9,1689 g $Al(NO_3)_3$, 0,0028 g $MnF_2$, 0,4145 g $Y_2O_3$, 0,4219 g $Sc_2O_3$, 0,0797 g $Ce(NO_3)_3$ und 15 g Zitronensäure nach und nach mit Wasser zugegeben. Die Lösung wird im Trockenschrank bei 130 °C über Nacht eingeengt und der entstandene Citratprecursor gemörsert. Das Pulver wird 3 h bei 1000 °C unter Luft vorkalziniert und anschließend gemörsert. Danach wird das Produkt 4 h bei 1600 °C unter CO-Atmosphäre geheizt und erneut gemörsert.

**Beispiel 13: Allgemeines Beispiel zur LED Applikation der Leuchtstoffe**

Allgemeine Vorschrift zum Bau und zur Messung von pc-LEDs:

Eine Masse von $m_{LS}$ (in g) des im jeweiligen LED-Beispiel aufgeführten Leuchtstoffs wird abgewogen und mit $m_{Silikon}$ (in g) eines optisch transparenten Silikons versetzt und anschließend in einem Planeten-Zentrifugalmischer homogen vermischt, so dass die Leuchtstoffkonzentration in der Gesamtmasse $c_{LS}$ (in Gew.-%) beträgt. Das so erhaltene Silikon-Leuchtstoff-Gemisch wird mit Hilfe eines automatischen Dispensers auf den Chip einer blauen Halbleiter-LED aufgebracht und unter Wärmezufuhr ausgehärtet. Die in den vorliegenden Beispielen für die LED-Charakterisierung verwendeten blauen Halbleiter-LEDs weisen eine Emissionswellenlänge von 442 nm auf und werden mit 350 mA Stromstärke betrieben. Die lichttechnische Charakterisierung der LED erfolgt mit einem Spektrometer der Fa. Instrument Systems - Spektrometer CAS 140 und einer damit verbundenen Integrationskugel ISP 250. Charakterisiert wird die LED über die Ermittlung der wellenlängenabhängigen spektralen Leistungsdichte. Das so erhaltene Spektrum des von der LED emittierten Lichts wird zur Berechnung der Farbpunktkoordinaten CIE x und y und des Lichtstroms $\Phi_v$ (in lm) verwendet.

**Beispiel 14: Herstellung einer pc-LED unter Einsatz des Leuchtstoffs gemäß Beispiel 1**

| | |
|---|---|
| $m_{LS}$: | 1.3 g |
| $m_{Silikon}$: | 8.7 g |
| CLS: | 13 Gew.-% |
| CIE (1931) x: | 0.269 |
| CIE (1931) y: | 0.358 |
| $\Phi_v$: | 57 lm |

**Beispiel 15: Herstellung einer pc-LED unter Einsatz des Leuchtstoffs gemäß Beispiel 3**

| | |
|---|---|
| $m_{LS}$: | 1.2 g |
| $m_{Silikon}$: | 8.8 g |
| CLS: | 12 Gew.-% |
| CIE (1931) x: | 0.284 |
| CIE (1931) y: | 0.354 |
| $\Phi_v$: | 56 lm |

**Beispiel 16: Herstellung einer pc-LED unter Einsatz des Leuchtstoffs gemäß Beispiel 6**

| | |
|---|---|
| $m_{LS}$: | 1.5 g |
| $m_{Silikon}$: | 8.5 g |
| CLS: | 15 Gew.-% |
| CIE (1931) x: | 0.238 |
| CIE (1931) y: | 0.394 |
| $\Phi_v$: | 63 lm |

**Beispiel 17: Herstellung einer pc-LED unter Einsatz des Leuchtstoffs gemäß Beispiel 8**

| | |
|---|---|
| $m_{LS}$: | 1.5 g |
| $m_{Silikon}$: | 8.5 g |
| $C_{LS}$: | 15 Gew.-% |
| CIE (1931) x: | 0.275 |
| CIE (1931) y: | 0.383 |

(fortgesetzt)

| | |
|---|---|
| $\Phi_v$: | 65 lm |

**Beschreibung der Figuren**

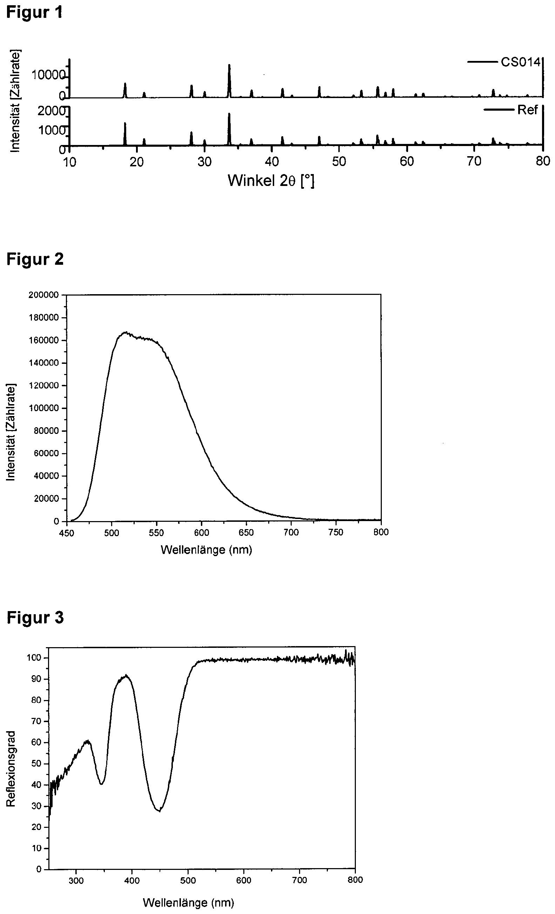

**Figur 1:** Pulver-Röntgendiffraktogramm von $Lu_{3-x}Al_{5-y}O_{12-z}$: $Ce^{3+}$ (0,5%) $Mn^{2+}$ (0,1%) $F^-$(0,1%) (Beispiel 1) (oben) mit dem Referenzbeugungsdiagramm des kubischen Lu-Granats (12005-21-9) (unten).

**Figur 2:** Emissionsspektrum von $Lu_{3-x}A)_{5-y}O_{12-z}$: $Ce^{3+}$ (0,5%) $Mn^{2+}$ (0,1%) $F$-(0,1%) (Beispiel 1).

**Figur 3:** Reflexionsspektrum von $Lu_{3-x}Al_{5-y}O_{12-z}$ : $Ce^{3+}$ (0,5%) $Mn^{2+}$ (0,1%) $F^-$(0,1%) (Beispiel 1).

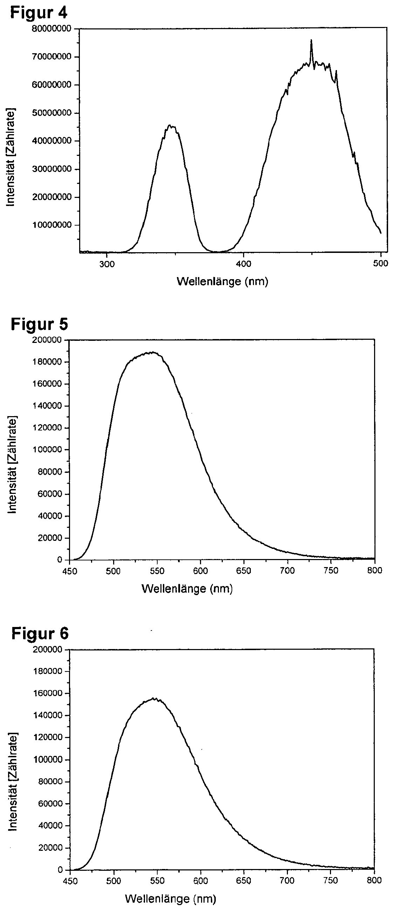

**Figur 4:** Anregungsspektrum von $Lu_{3-x}Al_{5-y}O_{12-z}$: $Ce^{3+}$ (0,5%) $Mn^{2+}$ (0,1%) $F^-$(0,1%) (Beispiel 1).

**Figur 5:** Emissionsspektrum von $Lu_{3-x}Al_{5-y}O_{12-z}$ : $Ce^{3+}$ (1,0%) $Mn^{2+}$ (0,1%) $F^-$ (0,1%) (Beispiel 2).

**Figur 6:** Emissionsspektrum von $Lu_{3-x}Al_{5-y}O_{12-z}$ : $Ce^{3+}$ (1,5%) $Mn^{2+}$ (0,1%)$F^-$(0,1%) (Beispiel 3).

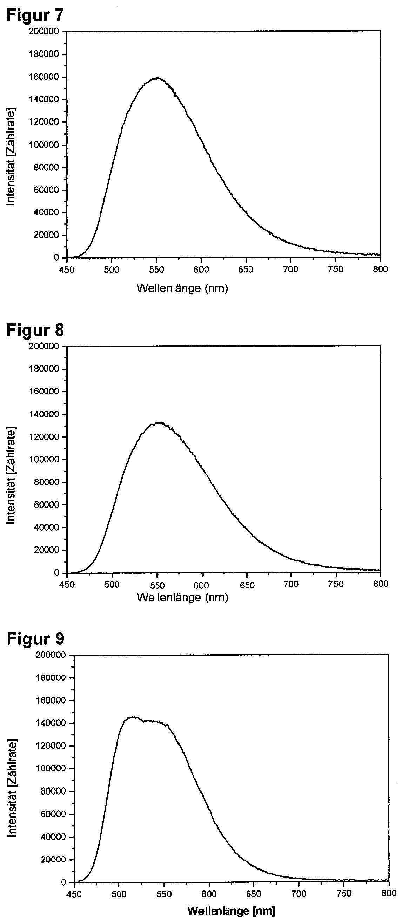

**Figur 7:** Emissionsspektrum von $Lu_{3-x}Al_{5-y}O_{12-z}$: $Ce^{3+}$ (2,0%) $Mn^{2+}$ (0,1%) $F^-$(0,1%) (Beispiel 4).

**Figur 8:** Emissionsspektrum von $Lu_{3-x}Al_{5-y}O_{12-z}$: $Ce^{3+}$ (2,5%) $Mn^{2+}$(0,1%) $F^-$ (0,1%) (Beispiel 5).

**Figur 9:** Emissionsspektrum von $Lu_{3-x}Al_{5-y}O_{12-z}$ : $Ce^{3+}$ (0,5%) $Mn^{2+}$ (0,5%) $F^-$ (0,5%) (Beispiel 6).

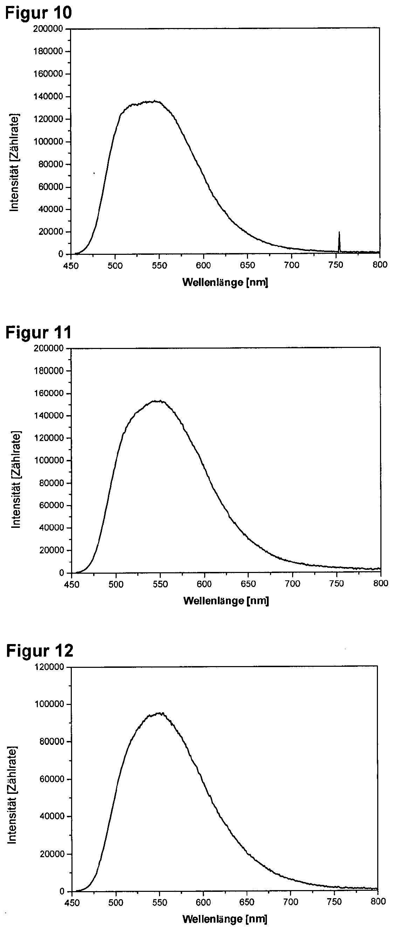

**Figur 10:** Emissionsspektrum von $Lu_{3-x}Al_{5-y}O_{12-z}$ : $Ce^{3+}$ (1,0%) $Mn^{2+}$ (0,5%) $F^-$ (0,5%) (Beispiel 7).

**Figur 11:** Emissionsspektrum von $Lu_{3-x}Al_{5-y}O_{12-z}$ : $Ce^{3+}$ (1,5%) $Mn^{2+}$ (0,5%) $F^-$ (0,5%) (Beispiel 8).

**Figur 12:** Emissionsspektrum von $Lu_{3-x}Al_{5-y}O_{12-z}$ : $Ce^{3+}$ (2,0%) $Mn^{2+}$ (0,5%) $F^-$ (0,5%) (Beispiel 9).

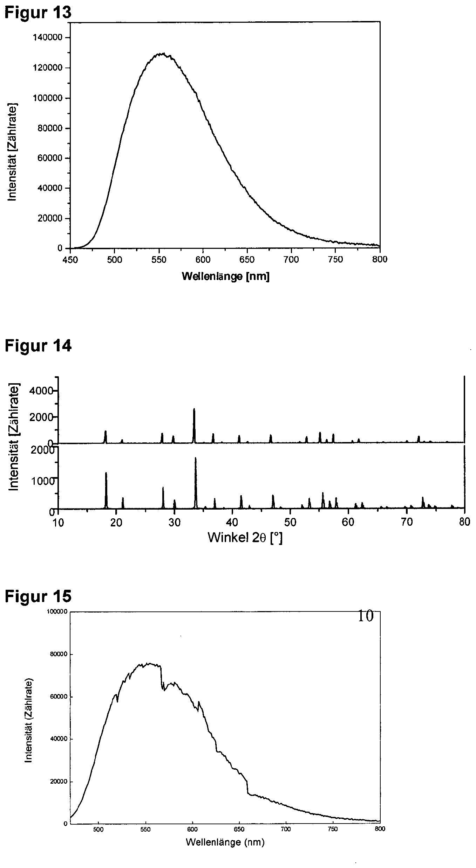

**Figur 13:** Emissionsspektrum von $Lu_{3-x}Al_{5-y}O_{12-z}$ : $Ce^{3+}$ (2,5%) $Mn^{2+}$ (0,5%) $F^-$ (0,5%) (Beispiel 10).

**Figur 14:** Pulver-Röntgendiffraktogramm von $Lu_{2,37}Gd_{0,6}Ce_{0,03}Mn_{0,005}Al_{3,995}GaO_{11,995}F_{0,005}$ (Beispiel 11) (oben) mit dem Referenzbeugungsdiagramm des kubischen Lu-Granats (12005-21-9) (unten).

**Figur 15:** Emissionsspektrum von $Lu_{2,37}Gd_{0,6}Ce_{0,03}Mn_{0,005}Al_{3,995}GaO_{11,995}F_{0,005}$ (Beispiel 11).

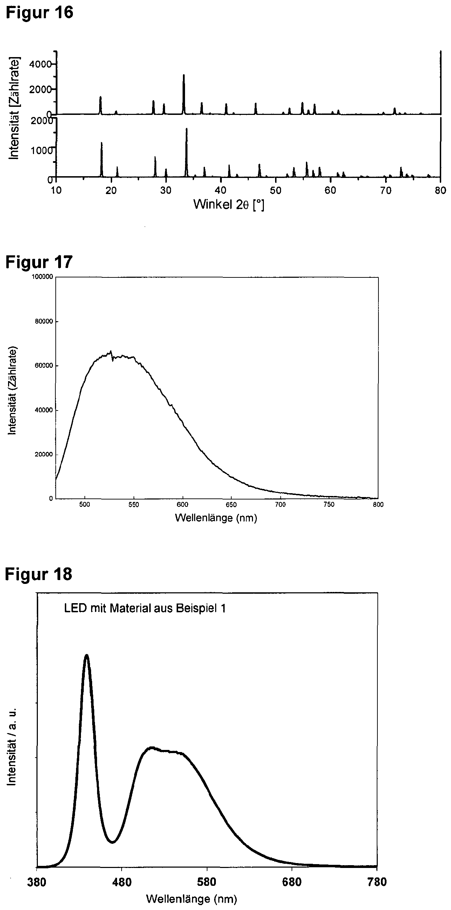

**Figur 16:** Pulver-Röntgendiffraktogramm von $Lu_{2,37}Y_{0,6}Ce_{0,03}Mn_{0,005}Al_{3,995}ScO_{11,995}F_{0,005}$ (Beispiel 12) (oben) mit dem Referenzbeugungsdiagramm des kubischen Lu-Granats (12005-21-9) (unten).

**Figur 17:** Emissionsspektrum von $Lu_{2,37}Y_{0,6}Ce_{0,03}Mn_{0,005}Al_{3,995}ScO_{11,995}F_{0,005}$ (Beispiel 12).

**Figur 18:** LED-Spektrum einer leuchtstoffkonvertierten LED aus Beispiel 14, die das Material aus Beispiel 1 enthält.

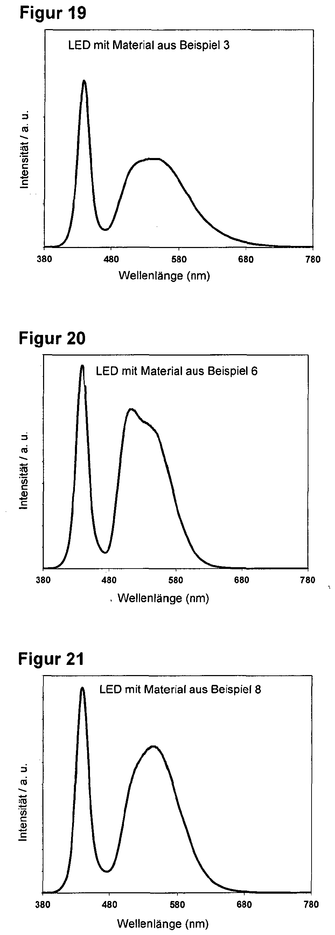

**Figur 19:** LED-Spektrum einer leuchtstoffkonvertierten LED aus Beispiel 15, die das Material aus Beispiel 3 enthält.

**Figur 20:** LED-Spektrum einer leuchtstoffkonvertierten LED aus Beispiel 16, die das Material aus Beispiel 6 enthält.

**Figur 21:** LED-Spektrum einer leuchtstoffkonvertierten LED aus Beispiel 17, die das Material aus Beispiel 8 enthält.

**Patentansprüche**

1. Verbindung der Formel (1),

$$M_{3-x}Ce_x(Al_{5-y-z-w}Ga_zSc_w)Mn_yO_{12-y}Hal_y \qquad (1)$$

wobei für die verwendeten Symbole und Indizes gilt:

M ist ausgewählt aus der Gruppe bestehend aus Y, Gd, Lu oder Tb oder Mischungen aus zwei oder mehr dieser Metalle;
Hal ist ausgewählt aus der Gruppe bestehend aus F, Cl, Br oder I oder Mischungen aus zwei oder mehr dieser Elemente;

$$0.005 \leq x \leq 0.3;$$

$$0 < y \leq 0.2;$$

$$0 \leq z \leq 1.0;$$

$$0 \leq w \leq 1.0.$$

**2.** Verbindung nach Anspruch 1, **dadurch gekennzeichnet, dass** M ausgewählt ist aus der Gruppe Y, Lu oder einer Mischung aus Y und Lu.

**3.** Verbindung nach Anspruch 1 oder 2, **dadurch gekennzeichnet, dass** Hal ausgewählt ist aus der Gruppe bestehend aus F und Cl.

**4.** Verbindung nach einem oder mehreren der Ansprüche 1 bis 3, **dadurch gekennzeichnet, dass** gilt: $0.005 \leq x \leq 0.20$.

**5.** Verbindung nach einem oder mehreren der Ansprüche 1 bis 4, **dadurch gekennzeichnet, dass** gilt: $0.001 \leq y \leq 0.2$.

**6.** Verbindung nach einem oder mehreren der Ansprüche 1 bis 5, **dadurch gekennzeichnet, dass** gilt: $0 \leq z \leq 0.5$ und $0 \leq w \leq 0.5$, wobei mindestens einer der Indizes z und/oder w = 0 ist.

**7.** Verbindung nach einem oder mehreren der Ansprüche 1 bis 6, **dadurch gekennzeichnet, dass** für die verwendeten Symbole und Inzides gilt:

M ist ausgewählt aus der Gruppe bestehend aus Y oder Lu oder Mischungen dieser Metalle;
Hal ist ausgewählt aus der Gruppe bestehend aus F oder Cl oder Mischungen dieser Elemente;

$$0.005 \leq x \leq 0.20;$$

$$0.001 \leq y \leq 0.2;$$

$$0 \leq z \leq 0.5;$$

$$0 \leq w \leq 0.5,$$

wobei mindestens einer der Indizes z und/oder w = 0 ist.

**8.** Verbindung nach einem oder mehreren der Ansprüche 1 bis 7, **dadurch gekennzeichnet, dass** die Verbindung auf der Oberfläche mit einer anderen Verbindung beschichtet ist.

9. Verfahren zur Herstellung einer Verbindung nach einem oder mehreren der Ansprüche 1 bis 8, umfassend die Schritte:

   a) Herstellung einer Lösung enthaltend M, Al, Mn, Ce, Hal und gegebenenfalls Ga und/oder Sc;
   b) Zugabe von Zitronensäure oder Weinsäure;
   c) Trocknen; und
   d) Kalzinieren der Mischung bei erhöhter Temperatur.

10. Verwendung einer Verbindung nach einem oder mehreren der Ansprüche 1 bis 8 als Leuchtstoff oder Konversionsleuchtstoff zur teilweisen oder vollständigen Konversion von blauer oder im nahen UV-liegenden Emission in Licht mit größerer Wellenlänge.

11. Emissions-konvertierendes Material umfassend eine Verbindung nach einem oder mehreren der Ansprüche 1 bis 8 und optional einen oder mehrere weitere Konversionsleuchtstoffe.

12. Lichtquelle, enthaltend mindestens eine Primärlichtquelle und mindestens eine Verbindung nach einem oder mehreren der Ansprüche 1 bis 8 oder ein emissionskonvertierendes Material nach Anspruch 11.

13. Beleuchtungseinheit, enthaltend mindestens eine Lichtquelle nach Anspruch 12.

14. Keramik, enthaltend mindestens eine Verbindung nach einem oder mehreren der Ansprüche 1 bis 8 oder mindestens ein Emissionskonvertierendes Material nach Anspruch 11 und optional ein oder mehrere Matrixmaterialien.

**Claims**

1. Compound of the formula (1),

$$M_{3-x}Ce_x(Al_{5-y-z-w}Ga_zSc_w)Mn_yO_{12-y}Hal_y \qquad (1)$$

where the following applies to the symbols and indices used:

   M is selected from the group consisting of Y, Gd, Lu or Tb or mixtures of two or more of these metals;
   Hal is selected from the group consisting of F, Cl, Br or I or mixtures of two or more of these elements;

$$0.005 \leq x \leq 0.3;$$

$$0 < y \leq 0.2;$$

$$0 \leq z \leq 1.0;$$

$$0 \leq w \leq 1.0.$$

2. Compound according to Claim 1, **characterised in that** M is selected from the group Y, Lu or a mixture of Y and Lu.

3. Compound according to Claim 1 or 2, **characterised in that** Hal is selected from the group consisting of F and Cl.

4. Compound according to one or more of Claims 1 to 3, **characterised in that** the following applies: $0.005 \leq x \leq 0.20$.

5. Compound according to one or more of Claims 1 to 4, **characterised in that** the following applies: $0.001 \leq y \leq 0.2$.

6. Compound according to one or more of Claims 1 to 5, **characterised in that** the following applies: $0 \leq z \leq 0.5$ and $0 \leq w \leq 0.5$, where at least one of the indices z and/or w is = 0.

7. Compound according to one or more of Claims 1 to 6, **characterised in that** the following applies to the symbols and indices used:

M is selected from the group consisting of Y or Lu or mixtures of these metals;
Hal is selected from the group consisting of F or Cl or mixtures of these elements;

$$0.005 \leq x \leq 0.20;$$

$$0.001 \leq y \leq 0.2;$$

$$0 \leq z \leq 0.5;$$

$$0 \leq w \leq 0.5,$$

where at least one of the indices z and/or w is = 0.

8. Compound according to one or more of Claims 1 to 7, **characterised in that** the compound is coated on the surface with another compound.

9. Process for the preparation of a compound according to one or more of Claims 1 to 8, comprising the steps:

a) preparation of a solution comprising M, Al, Mn, Ce, Hal and optionally Ga and/or Sc;
b) addition of citric acid or tartaric acid;
c) drying; and
d) calcination of the mixture at elevated temperature.

10. Use of a compound according to one or more of Claims 1 to 8 as phosphor or conversion phosphor for the partial or complete conversion of blue or near-UV emission into light having a longer wavelength.

11. Emission-converting material comprising a compound according to one or more of Claims 1 to 8 and optionally one or more further conversion phosphors.

12. Light source comprising at least one primary light source and at least one compound according to one or more of Claims 1 to 8 or an emission-converting material according to Claim 11.

13. Lighting unit comprising at least one light source according to Claim 12.

14. Ceramic comprising at least one compound according to one or more of Claims 1 to 8 or at least one emission-converting material according to Claim 11 and optionally one or more matrix materials.

## Revendications

1. Composé de la formule (1) :

$$M_{3-x}Ce_x(Al_{5-y-z-w}Ga_zSc_w)Mn_yO_{12-y}Hal_y \qquad (1)$$

formule dans laquelle ce qui suit s'applique aux symboles et indices qui sont utilisés :

M est sélectionné parmi le groupe qui est constitué par Y, Gd, Lu ou Tb ou parmi des mélanges de deux ou plus de ces métaux ;
Hal est sélectionné parmi le groupe qui est constitué par F, Cl, Br ou I ou parmi des mélanges de deux ou plus de ces éléments ;

$$0,005 \leq x \leq 0,3 ;$$

$$0 < y \leq 0,2 ;$$

$$0 \leq z \leq 1,0 ;$$

$$0 \leq w \leq 1,0.$$

**2.** Composé selon la revendication 1, **caractérisé en ce que** M est sélectionné parmi le groupe qui est constitué par Y, Lu ou parmi un mélange de Y et de Lu.

**3.** Composé selon la revendication 1 ou 2, **caractérisé en ce que** Hal est sélectionné parmi le groupe qui est constitué par F et Cl.

**4.** Composé selon une ou plusieurs des revendications 1 à 3, **caractérisé en ce que** ce qui suit s'applique : $0,005 \leq x \leq 0,20$.

**5.** Composé selon une ou plusieurs des revendications 1 à 4, **caractérisé en ce que** ce qui suit s'applique : $0,001 \leq y \leq 0,2$.

**6.** Composé selon une ou plusieurs des revendications 1 à 5, **caractérisé en ce que** ce qui suit s'applique : $0 \leq z \leq 0,5$ et $0 \leq w \leq 0,5$, où au moins l'un des indices z et/ou w est = 0.

**7.** Composé selon une ou plusieurs des revendications 1 à 6, **caractérisé en ce que** ce qui suit s'applique aux symboles et indices qui sont utilisés :

M est sélectionné parmi le groupe qui est constitué par Y ou Lu ou parmi des mélanges de ces métaux ;
Hal est sélectionné parmi le groupe qui est constitué par F ou Cl ou parmi des mélanges de ces éléments ;

$$0,005 \leq x \leq 0,20 ;$$

$$0,001 \leq y \leq 0,2 ;$$

$$0 \leq z \leq 0,5 ;$$

$$0 \leq w \leq 0,5,$$

où au moins l'un des indices z et/ou w est = 0.

**8.** Composé selon une ou plusieurs des revendications 1 à 7, **caractérisé en ce que** le composé est déposé sous forme de revêtement sur la surface avec un autre composé.

**9.** Procédé pour la préparation d'un composé selon une ou plusieurs des revendications 1 à 8, comprenant les étapes de :

a) préparation d'une solution qui comprend M, Al, Mn, Ce, Hal et en option Ga et/ou Sc ;
b) ajout d'acide citrique ou d'acide tartarique ;
c) séchage ; et
d) calcination du mélange à température élevée.

**10.** Utilisation d'un composé selon une ou plusieurs des revendications 1 à 8 en tant que phosphore ou que phosphore de conversion pour la conversion partielle ou complète d'une émission de bleu ou des UV proches selon une lumière qui présente une longueur d'onde plus longue.

**11.** Matériau de conversion d'émission comprenant un composé selon une ou plusieurs des revendications 1 à 8 et en option un ou plusieurs autres phosphores de conversion.

**12.** Source de lumière comprenant au moins une source de lumière primaire et au moins un composé selon une ou plusieurs des revendications 1 à 8 ou un matériau de conversion d'émission selon la revendication 11.

**13.** Unité d'éclairage comprenant au moins une source de lumière selon la revendication 12.

**14.** Céramique comprenant au moins un composé selon une ou plusieurs des revendications 1 à 8 ou au moins un matériau de conversion d'émission selon la revendication 11 et en option un ou plusieurs matériau(x) de matrice.

## Figur 1

## Figur 2

## Figur 3

## Figur 4

## Figur 5

## Figur 6

## Figur 7

## Figur 8

## Figur 9

## Figur 10

## Figur 11

## Figur 12

**Figur 13**

**Figur 14**

**Figur 15**

## Figur 16

## Figur 17

## Figur 18

LED mit Material aus Beispiel 1

## Figur 19

LED mit Material aus Beispiel 3

Intensität / a. u.

Wellenlänge (nm)

## Figur 20

LED mit Material aus Beispiel 6

Intensität / a. u.

Wellenlänge (nm)

## Figur 21

LED mit Material aus Beispiel 8

Intensität / a. u.

Wellenlänge (nm)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2009079094 A
- US 6409938 B1
- JP 4304290 A
- WO 9110715 A
- WO 9927033 A
- US 20070298250 A
- WO 2009065480 A
- WO 2010075908 A
- WO 2011091839 A

**In der Beschreibung aufgeführte Nicht-Patentliteratur**

- *J. of Appl. Phys.,* 2005, vol. 44 (21), L649-L651